(19) Europäisches Patentamt
European Patent Office
Office européen des brevets

(11) **EP 1 825 218 B1**

(12) **EUROPÄISCHE PATENTSCHRIFT**

(45) Veröffentlichungstag und Bekanntmachung des Hinweises auf die Patenterteilung:
**09.03.2016 Patentblatt 2016/10**

(21) Anmeldenummer: **05811363.0**

(22) Anmeldetag: **21.11.2005**

(51) Int Cl.:
**G01C 19/56** *(2012.01)*

(86) Internationale Anmeldenummer:
**PCT/EP2005/012449**

(87) Internationale Veröffentlichungsnummer:
**WO 2006/056389 (01.06.2006 Gazette 2006/22)**

(54) **VERFAHREN ZUR STEUERUNG/REGELUNG EINER PHYSIKALISCHEN GRÖSSE EINES DYNAMISCHEN SYSTEMS**

METHOD FOR CONTROLLING/REGULATING A PHYSICAL QUANTITY OF A DYNAMIC SYSTEM

PROCEDE POUR COMMANDER/REGULER UNE GRANDEUR PHYSIQUE D'UN SYSTEME DYNAMIQUE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **24.11.2004 DE 102004056699**

(43) Veröffentlichungstag der Anmeldung:
**29.08.2007 Patentblatt 2007/35**

(73) Patentinhaber: **Northrop Grumman LITEF GmbH 79115 Freiburg (DE)**

(72) Erfinder: **SPAHLINGER, Günter 70188 Stuttgart (DE)**

(74) Vertreter: **Müller Hoffmann & Partner Patentanwälte mbB St.-Martin-Strasse 58 81541 München (DE)**

(56) Entgegenhaltungen:
**WO-A-2004/099716**

**Beschreibung**

Die Erfindung betrifft ein Verfahren zur Steuerung bzw. Regelung einer physikalischen Größe eines dynamischen Systems, beispielsweise eines mikromechanischen Sensors, auf einen bestimmten Sollwert bzw. Sollwertverlauf unter Verwendung eines Pulsmodulators, durch den eine Folge diskreter Modulationssignale, die die Steuerung bzw. Regelung der physikalischen Größe bewirken, erzeugt werden. Die Erfindung betrifft ferner ein Verfahren zur gleichzeitigen Steuerung bzw. Regelung wenigstens zweier physikalischer Größen eines Systems, beispielsweise eines mikromechanischen Sensors, auf bestimmte Sollwerte bzw. Sollwertverläufe unter Verwendung eines Pulsmodulators, durch den eine Folge diskreter Modulationssignale, die die Steuerung bzw. Regelung der physikalischen Größen bewirkt, erzeugt werden.

Mikromechanische Sensoren sind bekannt. Ein prominentes Beispiel derartiger Sensoren sind Corioliskreisel (auch Vibrationskreisel genannt), die üblicherweise zur Drehratenmessung eingesetzt werden. Corioliskreisel weisen ein Massensystem auf, das in Schwingung versetzt wird. Die Schwingung ist in der Regel eine Überlagerung einer Vielzahl von Einzelschwinguiigen. Die Einzelschwingungen des Massensystems sind zunächst voneinander unabhängig und lassen sich jeweils abstrakt als "Resonatoren" auffassen. Zum Betrieb eines Corioliskreisels sind wenigstens zwei Resonatoren erforderlich: einer dieser Resonatoren (erster Resonator) wird künstlich zu Schwingungen angeregt, die im Folgenden als "Anregungsschwingung" bezeichnet wird. Der andere Resonator (zweiter Resonator) wird nur dann zu Schwingungen angeregt, wenn der Corioliskreisel bewegt/gedreht wird. In diesem Fall treten nämlich Corioliskräfte auf, die den ersten Resonator mit dem zweiten Resonator koppeln, der Anregungsschwingung des ersten Resonators Energie entnehmen und diese auf die Ausleseschwingung des zweiten Resonators übertragen. Die Schwingung des zweiten Resonators wird im Folgenden als "Ausleseschwingung" bezeichnet. Um Belegungen (insbesondere Drehungen) des Corioliskreisels zu ermitteln, wird die Ausleseschwingung abgegriffen und ein entsprechendes Auslesesignal (z. B. das Ausleseschwingungs-Abgriffsignal) daraufhin untersucht, ob Änderungen in der Amplitude der Ausleseschwingung, die ein Maß für die Drehung des Corioliskreisels darstellen, ausgetreten sind. Corioliskreisel können sowohl als Open-Loop-System als auch als Closed-Loop-System realisiert werden. In einem Closed-Loop-System wird über jeweilige Regelkreise die Amplitude der Ausleseschwingung fortlaufend auf einen festen Wert - vorzugsweise Null - rückgestellt.

Im Folgenden wird unter "Resonator" ein schwingfähiges Massensystem - das gegebenenfalls mechanische Federn beinhaltet verstanden. Hierfür wird in der Beschreibung auch der Begriff "Schwinger" als Synonym verwendet.

Zur detaillierten Funktionsweise der Corioliskreisel sei beispielhaft auf die Offenlegungsschrift DE 102 48 733 A1 verwiesen. Bisherige Corioliskreisel (insbesondere der in DE 102 48 733 A1 beschriebene Corioliskreisel) haben zum Nachteil, dass mehrere Digital-Analog-Wandler notwendig sind, um aus den digitalen Rückstell- bzw. Regelungssignalen entsprechende Kraftimpulse zu erzeugen. Digital-Analog-Wandler sind jedoch teuer und benötigen viel elektrische Leistung. Ferner lassen sie sich nur schlecht mit anderen elektronischen Bauteilen integrieren, was der Miniaturisierung Grenzen setzt.

Zur Vermeidung dieses Nachteils ist es bekannt, die Digital-Analog-Wandler durch einen Pulsmodulator zu ersetzten. An die Stelle des analogen Ausgangssignals der Digital-Analogwandler treten dann quantisierte Ausgangssignale des Pulsmodulators.

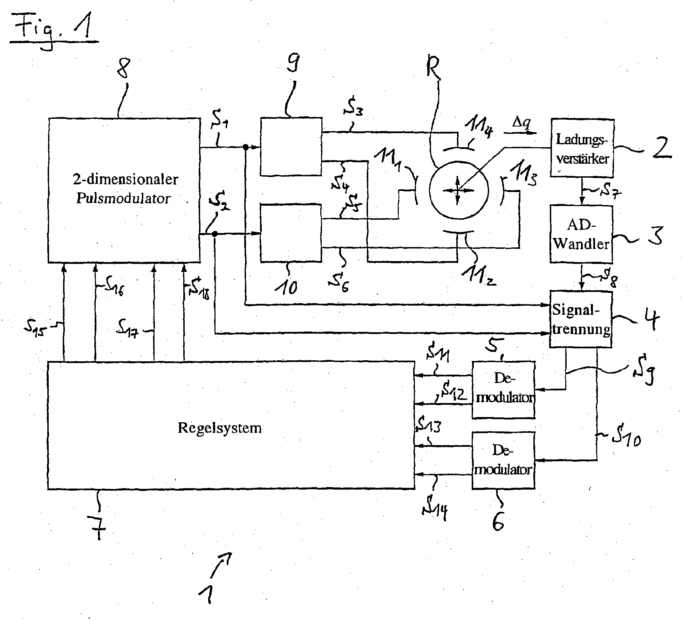

Im Folgenden soll unter Bezugnahme auf Fig. 1 ein derartiger Corioliskreisel näher erläutert werden.

Fig. 1 zeigt eine Auswerte-/Regelelektronik 1, die einen Ladungsverstärker 2, einen Analog-Digital-Wandler 3, eine Signaltrennung 4, einen ersten Demodulator 5, einen zweiten Demodulator 6, ein Regelsystem 7, einen zweidimensionalen Pulsmodulator 8, eine erste und zweite Kraftimpuls-Umwandlungseinheit 9, 10, und eine erste bis vierte Kraftgeberelektrode $11_1$ bis $11_4$ aufweist.

Die Gesamtheit der mit Bezugsziffern 2 bis 11 gekennzeichneten Bauteile bildet zwei Regelkreise: Einen Regelkreis zur Einstellung der Amplituden, Frequenzen und Phasen der Anregungsschwingung und einen weiteren Regelkreis zur Einstellung der Amplituden, Frequenzen und Phasen der Ausleseschwingung.

Wie Fig. 1 zeigt, weist die erfindungsgemäße Schaltung lediglich einen Analog-Digital-Wandler 3 und keine Digital-Analog-Wandler auf. Die Digital-Analog-Wandler sind hier durch den zweidimensionalen Pulsmodulator 8 sowie die beiden Kraftimpuls-Umwandlungseinheiten 9, 10 ersetzt.

Im Folgenden soll die Funktionsweise der erfindungsgemäßen Auswerte-/Regelelektronik näher erläutert werden.

Um die Amplituden bzw. Frequenzen bzw. Phasen der Anregungsschwingung /Ausleseschwingung des Resopators R einzustellen, erzeugt der zweidimensionale Pulsmodulator 8 ein erstes und ein zweites ternär quantisiertes Ausgangssignal $S_1$, $S_2$, wobei das erste ternär quantisierte Ausgangssignal $S_1$ in der ersten Kraftimpuls-Umwandlungseinheit 9 in Kraftimpulssignale (Spannungssignale) $S_3$, $S_4$ umgewandelt wird. Entsprechend wird das zweite ternär quantisierte Ausgangssignal $S_2$ durch die zweite Kraftimpuls-Umwandlungseinheit 10 in Kraftimpulssignale (Spannungssignale) $S_5$, $S_6$ umgewandelt. Vorzugsweise können die ternär quantisierten Ausgangssignale $S_1$, $S_2$ jeweils die Werte 1, 0 und -1 annehmen. Hat das Signal $S_1$ beispielsweise den Wert +1, so erzeugt die erste Kraftimpuls-Umwandlungs-

einheit aus dem Signal $S_1$ zwei Kraftimpulssignale $S_3$, $S_4$, die einen Kraftimpuls hervorrufen. Diese Kraftimpulssignale $S_3$, $S_1$ erzeugen zwischen den zweiten und vierten Kraftgeberelektroden $11_2$, $11_4$ und dem Resonator R elektrische Felder, über die die Kraftimpulse bewirkt werden. Hat das Signal $S_1$ den Wert -1, so werden die Kraftimpulssignale $S_3$, $S_4$ so erzeugt, dass resultierende Kraftimpulse entgegengesetzt zu den im Fall $S_1 = 1$ erzeugten Kraftimpulsen ausgerichtet sind. Hat das Signal $S_1$ den Wert 0, so liegen zwischen den Kraftgeberelektroden $11_2$, $11_4$ und dem Resonator R keine elektrischen Felder oder zwei elektrische Felder, die sich gegenseitig kompensieren, an. Jeder Kraftimpuls resultiert also aus einem einzelnen elektrischen Feld, das entweder zwischen der Kraftgeberelektrode 112 und dem Resonator R oder zwischen der Kraftgeberelektrode $11_4$ und dem Resonator R anliegt.

Entsprechend der folgenden Tabelle werden also beispielsweise folgende Potenziale (0 bzw. $U_0$) an die zweite und vierte Kraftgeberelektrode $11_2$, $11_4$ angelegt:

| $S_1$ | $11_4$ | $11_2$ |
|---|---|---|
| -1 | 0 | +/-$U_0$ |
| 0 | 0 oder +/-$U_0$ | 0 oder +/-$U_0$ |
| 1 | +/-$U_0$ | 0 |

Hat das Potenzial $U_0$ ein negatives Vorzeichen, so ist die resultierende Kraft aufgrund der Quadratur des Potenzials immer positiv. Entsprechende Überlegungen gelten auch für das zweite ternär quantisierte Ausgangssignal $S_2$, das durch die zweite Kraftimpulsumwandlungseinheit 10 in ein fünftes und sechstes Kraftimpulssignal $S_5$, $S_6$ umgewandelt wird, die an die erste und dritte Kraftgeberelektrode $11_1$, $11_3$ angelegt werden. Beispielsweise werden über die Kraftgeberelektroden $11_2$, $11_4$ die Parameter der Anregungsschwingung, und über die Kraftgeberelektroden $11_1$, $11_3$ die Parameter der Ausleseschwingung eingestellt/geregelt.

Durch das Anlegen elektrischer Felder an die Kraftgeberelektroden $11_1$ bis $11_4$ wird zusätzlich zur Anregung des Resonators R auch bewirkt, dass elektrische Ladung auf eine bewegliche Mittelelektrode fließt. Diese Ladung wird über den Ladungsverstärker 2 gemessen, ein entsprechendes analoges Ausgangssignal $S_7$ durch den Analog-Digital-Wandler 3 in ein entsprechendes digitales Signal $S_8$ umgewandelt, aus dem durch die Signaltrennung 4 ein erstes digitales Auslesesignal $S_9$ und ein zweites digitales Auslesesignal $S_{10}$ erzeugt wird. Da die auf die Mittelelektrode geflossene Ladung von den Kapazitäten derjenigen Kraftgeberelektroden $11_1$ bis $11_4$ abhängig ist, an denen momentan ein elektrisches Feld anliegt, ist die geflossene Ladung ein Maß für die Amplituden bzw. Frequenzen oder sonstige Parameter der Anregungsschwingung /Ausleseschwingung des Resonators R. Daher kann durch die Signaltrennung 4 in Abhängigkeit momentaner und/oder zeitlich älterer Ausgangssignalwerte der ternär quantisierten Ausgangssignale $S_1$, $S_2$ die momentane Bewegung/Änderung der Bewegung des Resonators R rekonstruiert werden. Treten positive und negative Potenziale +/-$U_0$ auf, so muss die Signaltrennung 4 bei der Rekonstruktion weiterhin das Vorzeichen des Potenzials $U_0$ (der an den Kraftgeberelektroden $11_1$ bis $11_4$ anliegenden Spannung) berücksichtigen.

Vorteilhafterweise ist der zweidimensionale Pulsmodulator 8 so ausgelegt, dass sich die ternär quantisierten Ausgangssignale $S_1$ und $S_2$ niemals gleichzeitig ändern, da in der Regel die auf die Mittelelektrode fließende Ladung summarisch gemessen wird, d. h., dass Ladungsverschiebungen, die aus einer Überlagerung von zwei elektrischen Feldern resultieren, nur als Ganzes gemessen werden können, also nicht Teilen der Ladungsverschiebung einzelner elektrischen Felder zugeordnet werden kann. Die Zusatzbedingung zwischen den ternär quantisierten Ausgangssignalen $S_1$ und $S_2$ erlaubt es dann, eine eindeutige Zuordnung der geflossenen Ladung zu einem bestimmten elektrischen Feld zu erhalten, so dass genau zwischen Anregungsschwingung und Ausleseschwingung unterschieden werden kann. Eine weitere mögliche Bedingung in diesem Zusammenhang ist, festzulegen, dass zu einem bestimmten Zeitpunkt nur eines der beiden Signale $S_1$ und $S_2$ von Null verschiedene Werte annehmen darf.

Das erste digitale Auslesesignal $S_9$ wird durch den ersten Demodulator 5 in einen Realteil $S_{11}$ und einen Imaginärteil $S_{12}$ demoduliert. Analog hierzu wird das zweite digitale Auslesesignal $S_{10}$ durch den zweiten Demodulator 6 in einen Realteil $S_{13}$ und einen Imaginärteil $S_{14}$ demoduliert. Beispielsweise beinhaltet das erste digitale Auslesesignal $S_9$ Information über die Anregungsschwingung und das zweite digitale Auslesesignal $S_{10}$ Information über die Ausleseschwingung. Die Real- und Imaginärteile $S_{11}$ bis $S_{14}$ des ersten und zweiten digitalen Auslesesignals $S_9$, $S_{10}$ beaufschlagen das Regelsystem 7, das in Abhängigkeit dieser Signale Anregungs-/Kompensationssignale $S_{15}$ bis $S_{18}$ erzeugt. Beispielsweise stellt das Signal $S_{15}$ den Realteil und das Signal $S_{16}$ den Imaginärteil des digitalen Anregungs-/Kompensationssignals für die Anregungsschwingung dar, wohingegen das Signal $S_{16}$ den Realteil und das Signal $S_{18}$ den Imaginärteil eines digitalen Anregungs-/Kompensationssignals für die Ausleseschwingung darstellt.

Die digitalen Anregungs-/Kompensationssignale $S_{15}$ bis $S_{18}$ werden dem zweidimensionalen Pulsmodulator 8 zugeführt, der daraus die ternär quantisierten Ausgangssignale $S_1$, $S_2$ erzeugt.

Das vorangehend beschriebene Regelungsprinzip (die Verwendung einer digitalen Impulsfolge zur Regelung einer physikalischen Größe) ist nicht auf die Regelung von Anregungsschwingung/Ausleseschwingung beschränkt, sondern lässt sich auf vielerlei Art und Weise einsetzen: In mikromechanischen Sensoren ("MEMS": Mikro-Elektro-Mechanische Systeme) mit elektrostatischer Anregung bzw. Rückstellung eines Resonators, insbesondere im vorangehend beschriebenen Corioliskreisel, muss beispielsweise häufig die Resonanzfrequenz des Resonators auf einen vorgegebenen Wert eingestellt werden. Dies ist möglich durch die Verwendung elektrostatischer Rückstellfedern, deren (positive oder negative) Federkonstanten sich durch elektrische Spannungen einstellen lassen. Der Resonator wird in der Regel gebildet aus (vorzusweise parallel geschalteten) mechanischen Federn, an denen das schwingfähige Massensystem aufgehängt ist, und dem schwingungsfähigen Massenelement selbst. Die Resonanzfrequenz eines deratigen Resonators kann mittels der im Zusammenhang mit Fig. 1 erläuterten Regelungstechnik eingestellt werden. Das heißt, dass anstelle einer analogen, einstellbaren Spannung eine digitale Impulsfolge erzeugt wird, die die Resonanzfrequenz auf eine dem Mittel der Impulse entsprechende Resonanzfrequenz "trimmt". Beispielsweise kann durch eine entsprechende Schaltfolge der elektrostatischen Rückstellfedern auf Eigenresonanzen von 9000 Hz bzw. 9200 Hz (d.h. durch eine dazu korrespondierende Impulsfolge aus zwei Impulswerten) eine Eigenresonanz von 9100 Hz eingestellt werden. Dies hat - wie bereits erwähnt - den Vorteil, dass die kostspieligen und mit einem relativ großen Leistungsverbrauch behafteten Digital-Analog-Wandler eingespart werden können. Es ist also möglich, unter Verwendung diskreter Impulse die Resonanzfrequenz eines Resonators (zum Beispiel die des in Figur 1 gezeigten Resonators oder die eines Doppelresonators) zu regeln bzw. einzustellen. Hierzu können separate Regelkreise und separate Kraftgeberelektroden eingesetzt werden, die in Figur 1 nicht eingezeichnet sind. Die in Figur 1 gezeigte Signaltrennung müsste dann im Rekonstruktionsvorgang zusätzlich die zur Regelung der Resonanzfrequenz benötigten Signale/Kraftgeberelektroden berücksichtigen.

Es lässt sich zeigen, dass es zur Regelung/Einstellung der Resonanzfrequenz auf einen bestimmten Wert nicht genügt, eine einfache Verteilungsmethode zu wählen, die dafür sorgt, dass die mittlere Häufigkeit der Impulse der relativen Lage der gewünschten Eigenfrequenz innerhalb der schaltbaren Eigenfrequenz-Extremwerte entspricht. Dies hätte nämlich zur Folge, dass das schwingungsfähige Massenelement aufgrund des so genannten parametrischen Oszillator-Effekts unkontrollierte Amplituden- und Phasenfluktuationen ausüben würde, die im Extremfall eine Entdämpfung oder sogar ein instabiles Verhalten des Resonators zur Folge haben könnte ("parametrische Effekte"). Dies gilt analog für beliebige physikalische Größen, die mittels einer diskreten Impulsfolge auf einen besitmmten Wert eingestellt/geregelt werden sollen.

Die der Erfindung zugrunde liegende Aufgabe ist, ein Verfahren zur Steuerung/Regelung einer physikalischen Größe eines mikromechanischen Sensors (bzw. allgemeiner: eines dynamischen Systems) unter Verwendung eines Pulsmodulators bereitzustellen, das eine Unterdrückung eventuell dabei auftretender parametrischer Effekte erlaubt. Insbesondere soll ein Verfahren zur digitalen Regelung der Federkonstanten eines Resonators auf eine vorgegebene Resonanzfrequenz bei gleichzeitiger Unterdrückung parametrischer Effekte bereitgestellt werden.

Zur Lösung dieser Aufgabe stellt die Erfindung ein Verfahren gemäß Patentanspruch 1 und Patentanspruch 9 bereit. Weiterhin stellt die Erfindung eine Vorrichtung gemäß Patentanspruch 8 und Patentanspruch 15 bereit. Vorteilhafte Ausgestaltungen bzw. Weiterbildungen des Erfindungsgedankens finden sich in den Unteransprüchen.

Das erfindungsgemäße Verfahren zur Steuerung bzw. Regelung einer physikalischen Größe eines dynamischen Systems auf einen bestimmten Sollwert bzw. Sollwertverlauf benutzt einen Pulsmodulator, der eine Folge diskreter Modulationssignale, die die Steuerung bzw. Regelung der physikalischen Größe bewirken, erzeugt, und ist gekennzeichnet durch das wiederholte Durchführen folgender Schritte:

a) Zunächst wird ein exakter Wert bzw. eine Approximation für die Abweichung zwischen dem momentanen Sollwert und dem momentanen tatsächlichen Wert der physikalischen Größe ermittelt.
b) Nun wird die jeweilige Änderung in der Abweichung, die das Beibehalten des momentanen Modulationssignals bzw. das Überwechseln auf die anderen Modulationssignale zur Folge haben würde, ermittelt.
c) Schließlich wird dasjenige Modulationssignal gewählt, das zur besten Approximation des momentanen Sollwerts führt.

Durch das wiederholte Durchführen der Schritte (a) bis (c) wird die Steuerung bzw. Regelung der physikalischen Größe auf den Sollwert bzw. Sollwertverlauf bewirkt. Ein wichtiges Prinzip, das dem erfindungsgemäßen Verfahren zugrunde liegt, ist, dass in jedem Iterationsschritt, d. h. jedes Mal nach Durchführen des Schritts (a) die Auswirkungen aller erzeugbarer Modulationssignale auf den momentanen Istwert der physikalischen Größe bzw. auf den durch Approximation geschätzten Istwert der physikalischen Größe ermittelt werden. Das heißt, die Auswirkungen der einzelnen Modulationssignale werden simuliert, bevor der Pulsmodulator ein entsprechendes Modulationssignal tatsächlich erzeugt und damit Einfluss auf den momentanen Wert der physikalischen Größe nimmt. Es wird dasjenige Modulationssignal ausgewählt, das in der Simulation die "beste" Auswirkung auf die physikalische Größe hat, d. h., zur besten Approximation des momentanen Sollwerts führt. Der Vorteil eines derartigen Steuerungs-/Regelungsverfahrens ist, dass dieses leicht mit entsprechenden Steuerungs-Regelungsverfahren anderer physikalischer Größen kombiniert werden kann und gleichzeitig eine Unterdrückung parametrischer Effekte verhindert.

Das erfindungsgemäße Verfahren kann besonders vorteilhaft auf mikromechanische Sensoren mit einem Resonator angewandt werden. Die zu steuernde bzw. regelnde physikalische Größe könnte in diesem Fall beispielsweise die Resonanzfrequenz des Resonators sein. Alternativ könnten auch die Amplitude oder Phase einer Schwingung des Resonators gesteuert bzw. geregelt werden. Das erfindungsgemäße Verfahren lässt sich auch auf dynamische Systeme wie Pendelsysteme in Beschleunigungsmessern, Oszillatoren (elektrisch, elektromechanisch, mechanisch) mit einstellbarer Frequenz (z. B. für eine Taktfrequenzerzeugung) anwenden. Weitere in Frage kommende Systeme sind einstellbare Bandfilter, Quarzfilter, etc.. Sämtliche im Zusammenhang mit diesen Systemen relevanten physikalischen Größen können durch das erfindungsgemäße Verfahren geregelt werden. Die Erfindung ist nicht auf die oben explizit angeführten dynamischen Systeme beschränkt.

Wie bereits erwähnt, kann in Schritt (a) entweder der exakte Wert der Abweichung oder eine Approximation für die Abweichung zwischen dem momentanen Sollwert und dem momentanen tatsächlichen Wert der physikalischen Größe ermittelt werden. Zur Regelung der Resonanzfrequenz des Resonators ist es vorteilhaft, eine Approximation der Abweichung zu ermitteln. Grund hierfür ist, dass in einem mikromechanischen Sensor mit Rückstellung (Closed-Loop-System) die Amplitude einer zu regelnden Ausleseschwingung des Resonators fortlaufend auf Null zurückgestellt wird und in Folge dessen keine Schwingung untersucht und somit auch keine momentane Resonanzfrequenz abgelesen werden kann. Diesem Problem kann begegnet werden, indem zur Regelung der Resonanzfrequenz des Resonators die Schwingungsantwort des Resonators, die aus der Beaufschlagung des Resonators (bei gegebener Anfangsamplitude und Anfangsphase) mit einer Modulationssignal-Folge resultieren würde, simuliert wird, und die Modulationssignal-Folge so gewählt wird, dass sich in der Simulation eine möglichst genaue Approximation eines Schwingungs-Sollwertverlaufs des Resonators ergibt. Die Frequenz des Schwingungs-Sollwertverlaufs ist hierbei die zu regelnde Resonanzfrequenz des Resonators. Der "echte" Resonator wird mit der so erhaltenen Modulationssignal-Folge beaufschlagt.

Unter "Schwingungsantwort" wird hierbei die Reaktion des Resonators auf die Modulationssignalfolge, d.h. die aus der Modulationssignalfolge resultierende Eigenschwingung (Ausschwingvorgang) des Resonators verstanden. Der Ausschwingvorgang, der in der Simulation ausgeführt wird, ist so aufzufassen, dass in der Simulation der Resonator eine Anfangsauslenkung (Anfangsamplitude, Anfangsphase) erfährt und dann sich selbst überlassen wird, und die Modulationssignalfolge, deren Auswirkung auf den Ausschwingvorgang in der Simulation getestet wird, zwar die Phase und Amplitude des abklingenden (gedämpften) Ausschwingvorgang regelt (auf den idealen Sollwert), jedoch mit der Phase und Amplitude der Anfangsauslenkung "nichts zur tun" hat (diese ist "Randbedingung" und von der Modulationssignalfolge unabhängig).

Es wird also der gedämpfte, abklingende Eigenschwingungsvorgang des realen Resonators in Abhängigkeit einer Modulationssignal-Folge simuliert und in jedem Iterationsschritt beziehungsweise Zeitschritt (zeitdiskretes digitales Modulationsverfahren) die aufgrund der bisherigen Modulationssignale resultierende Schwingungsantwort mit einer idealen Eigenschwingung verglichen, die das System bei der zu regelnden Resonanzfrequenz aufweisen würde. Die Auswirkungen sämtlicher erzeugbarer Modulationssignale auf den momentanen Schwingungszustand des simulierten realen Resonators werden ermittelt, und im nächsten Iterationsschritt wird der Resonator in der Simulation mit dem Modulationssignal beaufschlagt, der zur besten Approximation des idealen Schwingungs-Sollwertverlaufs führt, d. h., die beste Übereinstimmung zwischen idealem (Eigen-)Schwingungsverlauf und simuliertem realen (Eigen-) Schwingungsverlauf ergibt.

Die Erzeugung der Modulationssignal-Folge zur Regelung der Resonanzfrequenz kann beispielsweise dadurch erfolgen, dass in der Simulation des Schwingungsverhaltens des realen Resonators gleichzeitig Amplitude und Phase der Schwingungsantwort (Eigenschwingung) auf bestimmte Sollwerte bzw. Sollwertverläufe geregelt werden. Dazu werden:

d) Für jedes erzeugbare Modulationssignal eine effektive Gesamtabweichung berechnet, die gegeben ist aus der Summe der Abweichungen zwischen den momentanen Sollwerten und entsprechenden in der Simulation geregelten Werten, die aus dem Beibehalten dieses Modulationssignals (wenn dieses Modulationssignal im vorherigen Iterationsschritt ausgewählt wurde) bzw. dem Überwechseln in dieses Modulationssignal (wenn im vorherigen Iterationsschritt ein anderes Modulationssignal ausgewählt wurde) resultieren würden.

e) Das Modulationssignal ausgewählt, für das die berechnete effektive Gesamtabweichung am geringsten ist.

f) Die Schritte d) und e) werden mehrmals wiederholt, d. h., in jedem Iterationsschritt wird einmal Schritt d) und anschließend einmal Schritt e) ausgeführt.

Es werden demnach bei der Erzeugung der Modulationssignal-Folge zwei physikalische Größen (Amplitude und Phase) gleichzeitig berücksichtigt. Die "effektive Gesamtabweichung" stellt demnach einen "globalen" Fehler dar, der die Summe aus Phasenfehler und Amplitudenfehler für ein erzeugbares Modulationssignal darstellt. Indem der "globale" Fehler möglichst klein gehalten wird (Schritt e)), wird bewirkt, dass stets diejenige physikalische Größe vorrangig geregelt wird, die am meisten zur Gesamtabweichung beiträgt, d. h., die den größten "Regelungsbedarf" hat.

Wenn auf die oben beschriebene Art und Weise Amplitude und Phase der Simulation auf den idealisierten Schwingungs-Sollwertverlauf geregelt sind, ist auch automatisch" die gewünschte Resonanzfrequenz des Resonators eingestellt.

Zur Verbesserung der Genauigkeit ist es sinnvoll, simultan zwei Schwingungsantworten (Eigenschwingungen) des Resonators, die aus der Beaufschlagung des Resonators mit einer Modulationssignal-Folge resultieren, zu simulieren. Für jede der Schwingungsantwörten werden hierbei gleichzeitig Amplitude und Phase der Schvvingungsantwort auf bestimmte Sollwerte/Sollwertverläufe geregelt. Die Sollphase der einen Schwingungsantwort ist gegenüber der Sollphase der anderen Schwingungsantwort um die Phase $\pi/2$ verschoben. Dabei wird:

g) Für jedes erzeugbare Modulationssignal den beiden Simulationen jeweils eine effektive Gesamtabweichung zugeordnet, die gegeben ist aus der Summe der Abweichungen zwischen den momentanen Sollwerten der Simulation und entsprechenden in der Simulation geregelten Werten, die aus dem Beibehalten dieses Modulationssignals (wenn dieses Modulationssignal im vorherigen Iterationsschritt ausgewählt wurde) bzw. dem Überwechseln in dieses Modulationssignal (wenn im vorherigen Iterationsschritt ein anderes Modulationssignal ausgewählt wurde) resultieren würde.

h) Die effektive Gesamtabweichung bezüglich desselben Modulationssignals aus beiden Simulationen addiert.

i) Das Modulationssignal ausgewählt, für das die im vorangehenden Schritt berechnete Summe am geringsten ist.

j) Die Schritte g) bis i) werden in jeder Iteration jeweils einmal durchlaufen.

Die Erfindung stellt ferner eine Einrichtung zur Steuerung/Regelung einer physikalischen Größe eines dynamischen Systems auf einen bestimmten Sollwert/Sollwertverlauf bereit, die einen Pulsmodulator aufweist, durch den eine Folge diskreter Modulationssignale, die die Steuerung/Regelung der physikalischen Größe bewirken, erzeugbär ist. Die Vorrichtung weist auf:

- eine Vergleichseinheit, durch die ein exakter Wert oder eine Approximation für die Abweichung zwischen dem momentanen Sollwert und dem momentanen tatsächlichen Wert der physikalischen Größe ermittelbar ist,
- eine mit der Vergleichseinheit verbundene Berechnungseinheit, durch die die jeweiligen Änderungen der durch die Vergleichseinheit ermittelten Abweichung, die das Beibehalten des momentanen Modulationssignals beziehungsweise das Überwechseln auf die anderen Modulationssignale zur Folge haben würde, berechenbar ist, und
- eine mit der Berechnungseinheit verbundene Entscheidereinheit, die in Abhängigkeit der durch die Vergleichseinheit berechneten AbweichungsÄnderungen entscheidet, welches Modulationssignal zur besten Approximation des momentanen Sollwerts führt, wobei die durch den Pulsmodulator erzeugte Modulationssignal-Folge durch die Entscheidereinheit steuerbar ist.

Die Erfindung stellt weiterhin ein Verfahren zur gleichzeitigen Steuerung bzw. Regelung wenigstens zweier physikalischer Größen eines dynamischen Systems auf bestimmte Sollwerte bzw. Sollwertverläufe unter Verwendung eines Pulsmodulators bereit, der eine Folge diskreter Modulationssignale, die die Steuerung/Regelung der physikalischen Größen bewirkt, erzeugt und ist gekennzeichnet durch das wiederholte Durchführung folgender Schritte:

a) Zunächst wird für jedes erzeugbare Modulationssignal eine effektive Gesamtabweichung berechnet, die gegeben ist aus der Summe der exakten Werte beziehungsweise der Approximationen für die Abweichungen zwischen den momentanen Sollwerten und entsprechenden tatsächlichen Werten der physikalischen Größen, die aus dem Beibehalten dieses Modulationssignals (wenn dieses Modulationssignal im vorherigen Taktzyklus ausgewählt wurde) beziehungsweise dem Überwechseln in dieses Modulationssignal (wenn im vorherigen Taktzyklus ein anderes Modulationssignal ausgewählt wurde) resultieren würden.

b) Es wird dasjenige Modulationssignal für die Steuerung/Regelung verwendet (im nächsten Taktzyklus), für das die berechnete effektive Gesamtabweichung am geringsten ist.

c) Durch das wiederholte Durchführen der Schritte a) und b) wird die Steuerung bzw. Regelung der physikalischen Größen auf entsprechende Sollwerte bzw. Sollwertverläufe bewirkt. Ein wichtiges Prinzip, das dem erfindungsgemäßen Verfahren zugrunde liegt, ist, dass in jedem Taktzyklus (Iterationsschritt) die Auswirkungen aller erzeugbarer Modulationssignale auf die momentanen Istwerte der physikalischen Größen bzw. auf die durch Approximation geschätzten Istwerte der physikalischen Größen ermittelt werden. Das heißt, die Auswirkungen der einzelnen Modulationssignale werden simuliert, bevor der Pulsmodulator ein entsprechendes Modulationssignal tatsächlich erzeugt und damit Einfluss auf die momentanen Werte der physikalischen Größen nimmt. Es wird dasjenige Modulationssignal ausgewählt, das in der Simulation die "beste" Auswirkung auf die physikalische Größe hat, d. h. zur besten Approximation des momentanen Sollwerts führt (Prinzip des "Durchspielens aller Möglichkeiten"). Der Vorteil eines derartigen Steuerung-/Regelungsverfahrens ist, dass prinzipiell beliebig viele physikalische Größen gleichzeitig geregelt werden können, und außerdem eine Unterdrückung parametrischer Effekte erzielt werden kann.

Das erfindungsgemäße Verfahren kann besonders vorteilhaft auf mikromechanische Sensoren mit einem Resonator angewandt werden. Die zu steuernden/regelnden physikalischen Größen könnten beispielsweise eine Resonanzfrequenz des Resonators sowie Amplituden bzw. Phasen der Anregungsschwingung und/oder Ausleseschwingung des Resonators sein.

Wie bereits erwähnt, können in Schritt a) entweder die exakten Werte der Abweichungen oder Approximationen für die Abweichungen zwischen dem momentanen Sollwert und den momentanen tatsächlichen Werten der physikalischen Größen ermittelt werden. Zur Regelung von Resonanzfrequenzen des Resonators ist es beispielsweise vorteilhaft, eine Approximation der Abweichung zu ermitteln. Grund hierfür ist, dass in einem mikromechanischen Sensor mit Rückstellung (Closed-Loop-System) die Amplitude einer zu regelnden Ausleseschwingung des Resonators fortlaufend auf Null zurückgestellt wird, und infolge dessen keine Schwingung untersucht und somit auch keine momentane Resonanzfrequenz abgelesen werden kann. Diesem Problem kann begegnet werden, wenn bei Regelung der Resonanzfrequenz des Resonators diesbezüglich (siehe Schritt a) weiter oben) zu ermittelnde Resonanzfrequenz-Abweichungs-Approximationen aufgefunden werden, indem:

- ein Eigenschwingungsvorgang des Resonators simuliert wird, den der Resonator bei bestimmten Schwingungs-Anfangsbedingungen sowie nach Beaufschlagung mit den bisher durch den Pulsmodulator erzeugten Modulationssignalen ausführen würde,
- berechnet wird, welche Auswirkung jedes erzeugbare Modulationssignal auf den simulierten Eigenschwingungsvorgang des Resonators haben würde, und die so hypothetisch resultierenden EigenschwingungsVerläufe mit einem Eigenschwingungs-Sollwertverlauf verglichen werden, der die gleichen Schwingungs-Anfängsbedingungen aufweist, und dessen Schwingungsfrequenz die zu regelnde Resonanzfrequenz ist,
- wobei die Abweichungen zwischen den hypothetisch resultierenden Eigenschwingungs-Verläufen und dem Eigenschwingungs-Sollwertverlauf die zu ermittelnden Resonanzfrequenz-Abweichungs-Approximationen darstellen.

In Verallgemeinerung des im letzten Absatz beschriebenen Verfahrens ist es möglich, Abweichungs-Approximationen beliebiger physikalischer Größen bzw. Parameter beliebiger Systeme (z. B. nichtlinearer und/oder zeitabhängiger Systeme) durch Simulation zu ermitteln, insofern ein numerisch simulierbares Modell für diese Größen/Parameter/Systeme aufgefunden werden kann (Beispiel: die Regelung eines Beschleunigungsmessers). Prinzipiell wäre es auch möglich, alle interessierenden Größen/Parameter simulationsbasierend zu regeln.

Es wird demnach ein gedämpfter, abklingender Eigenschwingungsvorgang des realen Resonators in Abhängigkeit einer Modulationssignal-Folge simuliert und in jedem Iterationsschritt bzw. Taktzyklus die aufgrund der bisherigen Modulationssignale resultierende Eigenschwingung mit einer "idealen" Eigenschwingung verglichen, die ein ideales System bei der zu regelnden Resonanzfrequenz aufweisen würde. Es werden die Auswirkungen sämtlicher erzeugbarer Modulationssignale auf den momentanen Schwingungszustand des simulierten realen Resonators ermittelt, und im nächsten Taktzyklus wird der Resonator in der Simulation mit dem Modulationssignal beaufschlagt, das in Schritt b) ausgewählt wurde, d. h. für das die effektive Gesamtabweichung (für sämtliche gleichzeitig zu regelnde physikalischen Größen) am geringsten ist.

Der Vergleich der hypothetisch resultierenden Eigenschwingungs-Verläufe mit dem Eigenschwingungs-Sollwertverlauf kann beispielsweise dadurch erfolgen, dass entsprechende Amplituden und Phasen der Verläufe miteinander verglichen werden. Dabei wird für jedes erzeugbare Modulationssignal eine Gesamtabweichung berechnet, die gegeben ist aus der Summe der Abweichungen zwischen den momentanen Sollwerten und entsprechenden Simulationswerten für Amplitude und Phase, die aus dem Beibehalten dieses Modulationssignals beziehungsweise dem Überwechseln in dieses Modulationssignal resultieren würden. Die Gesamtabweichungen stellen hierbei die zu ermittelnden Resonanzfrequenz-Abweichungs-Approximationen dar.

Beim Vergleich der simulierten Eigenschwingung mit dem Eigenschwingungs-Sollwertverlauf werden also gleichzeitig zwei physikalische Größen (Amplitude und Phase) berücksichtigt. Der Begriff "Gesamtabweichung" stellt demnach einen "globalen" Fehler dar, der in dieser Ausführungsform die Summe aus Phasenfehler und Amplitudenfehler bezüglich eines erzeugbaren Modulationssignals repräsentiert. Analog hierzu stellt die "effektive Gesamtabweichung" einen globalen Fehler dar, wobei ein Teil dieses globalen Fehlers die in dieser Ausführungsform ermittelten Gesamtabweichungen sind und ein weiterer Teil des globalen Fehlers aus den Abweichungen wenigstens einer weiteren zu regelnden physikalischen Größe resultieren. Indem der globale Fehler möglichst klein gehalten wird (Schritt b)), wird bewirkt, dass stets diejenige physikalische Größe vorrangig geregelt wird, die am meisten zur effektiven Gesamtabweichung beiträgt, d. h., die den größten "Regelungsbedarf" hat.

Wenn auf die oben beschriebene Art und Weise Amplitude und Phase der Simulation auf den idealisierten Eigenschwingungs-Sollwertverlauf "getrimmt" sind, ist auch automatisch die gewünschte Resonanzfrequenz des Resonators auf den Sollwert eingestellt.

Zur Verbesserung der Genauigkeit des erfindungsgemäßen Verfahrens ist es sinnvoll, simultan zwei Eigenschwingungsvorgänge des Resonators zu simulieren, wobei jeder Eigenschwingungsvorgang bezüglich Amplitude und Phase mit jeweiligen Sollwerten/Sollwertverläufen verglichen wird, und die Sollphase des einen Eigenschwingungsvorgangs gegenüber der Sollphase des anderen Eigenschwingungsvorgangs um die Phase $\pi/2$ verschoben ist. Dabei werden:

- für jedes erzeugbare Modulationssignal den beiden Simulationen jeweils eine Gesamtabweichung zugeordnet, die gegeben ist aus der Summe der Abweichungen zwischen den momentanen Sollwerten und entsprechenden Simulationswerten für Amplitude und Phase, die aus dem Beibehalten dieses Modulationssignals beziehungsweise dem Überwechseln in dieses Modulationssignal resultieren würden, und
- die Gesamtabweichungen bezüglich desselben Modulationssignals aus beiden Simulationen addiert, wobei die im vorangehenden Schritt berechneten Gesamtabweichungs-Summen die zu ermittelnden Resonanzfrequenz-Abweichungs-Approximationen darstellen.

Die Erfindung stellt weiterhin eine Einrichtung zur gleichzeitigen Steuerung bzw. Regelung wenigstens zweier physikalischer Größen eines dynamischen Systems auf bestimmte Sollwerte/Sollwertverläufe bereit. Die Einrichtung weist einen Pulsmodulator auf, durch den eine Folge diskreter Modulationssignale, die die Steuerung/Regelung der physikalischen Größen bewirkt, erzeugbar ist. Die Einrichtung weist ferner eine Berechnungseinheit auf, die für jedes erzeugbare Modulationssignal eine effektive Gesamtabweichung berechnet, die gegeben ist aus der Summe der exakten Werte beziehungsweise der Approximation für die Abweichungen zwischen den momentanen Sollwerten und entsprechenden tatsächlichen Werten der physikalischen Größen, die aus dem Beibehalten dieses Modulationssignals beziehungsweise dem Überwechseln in dieses Modulationssignal resultieren würden. Ferner ist eine mit der Berechnungseinheit verbundene Entscheidereinheit vorgesehen, die in Abhängigkeit der durch die Berechnungseinheit berechneten effektiven Gesamtabweichungen entscheidet, für welches Modulationssignal die berechnete effektive Gesamtabweichung am geringsten wäre, und den Pulsmodulator zur Erzeugung eines entsprechenden Modulationssignals ansteuert.

Die Erfindung wird im Folgenden unter Bezugnahme auf die Figuren in beispielsweiser Ausführungsform näher erläutert. Es zeigen:

Fig. 1      eine schematische Drastellung der Auswerte-/Regelelektronik eines Corioliskreisels mit Pulsmodulator.

Fig. 2      eine Nachbildung eines mechanischen Systems mit schwingfähiger Masse (kontinuierliche Darstellung).

Fig. 3      eine vektorisierte Darstellung der in Fig. 2 gezeigten Nachbildung.

Fig. 4      eine diskretisierte Darstellung der in Fig. 2 gezeigten Nachbildung.

Fig. 5      eine symmetrische diskretisierte Darstellung der in Fig. 2 gezeigten Nachbildung.

Fig. 6      eine erste alternative symmetrische Darstellung der in Fig. 2 gezeigten Nachbildung.

Fig. 7      eine zweite alternative symmetrische Darstellung der in Fig. 2 gezeigten Nachbildung.

Fig. 8      eine zeitabhängige Darstellung der in Fig. 5 gezeigten Darstellung.

Fig. 9      eine zeitabhängige Darstellung der in Fig. 6 gezeigten Darstellung.

Fig. 10     eine zeitabhängige Darstellung der in Fig. 7 gezeigten Darstellung.

Fig. 11     eine Nachbildung eines mechanischen Systems mit schwingfähiger Masse für den Fall zweier die schwingfähige Masse beaufschlagende Modulationssignale.

Fig. 12     eine zur in Fig. 11 gezeigten Nachbildung alternative Nachbildung.

Fig. 13     ein System zur Bestimmung von Phasen- und Amplitudenfehlern.

Fig. 14     eine Nachbildung eines mechanischen Systems mit schwingfähiger Masse, Fehlerbestimmung und Entscheider.

Fig. 15     die in Fig. 14 gezeigte Nachbildung mit zusätzlicher interner Entdämpfung.

**Fig. 16**  einen Ausschwingvorgang der schwingfähigen Masse des mechanischen Systems bei Phasenübereinstimmung mit der in einer Nachbildung simulierten Phase.

**Fig. 17**  das Spektrum des in Fig. 16 gezeigten Ausschwingvorgangs.

**Fig. 18**  einen Ausschwingvorgang der schwingfähigen Masse des mechanischen Systems bei nicht übereinstimmender Phase mit der in der Nachbildung des mechanischen Systems simulierten Phase.

**Fig. 19**  ein System mit zwei phasenverschobenen Nachbildungen einer schwingfähigen Masse eines mechanischen Systems.

**Fig. 20**  den Aufbau eines bekannten ternären Pulsmodulators.

**Fig. 21**  den Zusammenhang von Kräften, und Resonanzfrequenzen eines mechanischen Resonators, der mit vier Modulationssignalen beaufschlagt werden kann.

**Fig. 22**  den Aufbau eines modifizierten ternären Pulsmodulators.

**Fig. 23**  den Aufbau einer bevorzugten Ausführungsform einer Einrichtung zur Abstimmung der Resonanzfrequenz eines mechanischen Resonators.

**Fig. 24**  eine erste bevorzugte Ausführungsform einer Einrichtung zur gleichzeitigen Regelung von Resonanzfrequenz und Anregungs- bzw. Kompensationssignal eines mechanischen Resonators.

**Fig. 25**  eine zweite Ausführungsform einer Einrichtung zur gemeinsamen Steuerung von Resonanzfrequenz und Anregungs- bzw. Kompensationssignal eines mechanischen Resonators gemäß der Erfindung.

In den Figuren sind identische beziehungsweise einander entsprechende Bauteile bzw. Bauteilgruppen mit denselben Bezugsziffern gekennzeichnet.

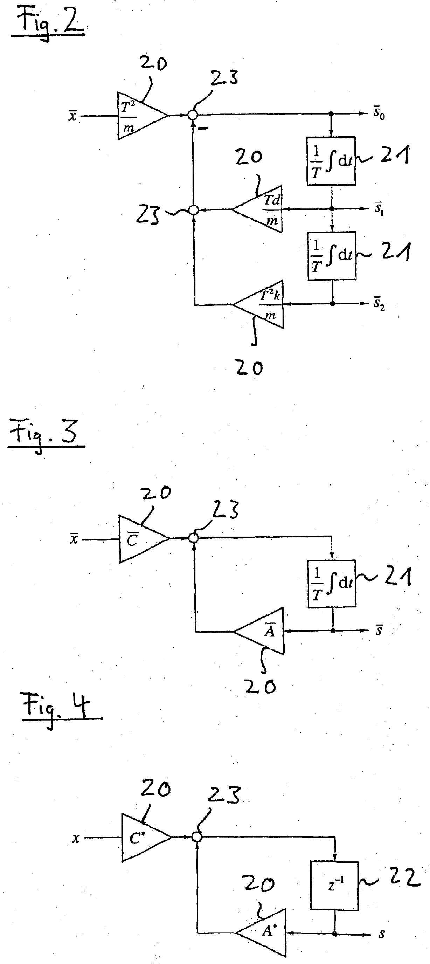

Wie bereits beschrieben wurde, ermöglicht das erfindungsgemäße Verfahren, gleichzeitig die Resonanzfrequenz eines Resonators einzustellen sowie Schwingungsamplituden des Resonators anzuregen bzw. rückzustellen. Im Folgenden sei unter Bezugnahme auf die Fig. 2 bis 19 eine bevorzugte Ausführungsform zur Regelung der Resonanzfrequenz des Resonators erläutert.

Zum besseren Verständnis sei in der folgenden Beschreibung kurz auf die theoretischen Grundlagen eines mechanischen Systems mit schwingfähiger Masse sowie dessen Darstellbarkeit als analoges bzw. diskretes System eingegangen.

**1. Analyse des mechanischen Schwingers**

**1.1 Differenzialgleichung**

Gegeben sei ein schwingfähiges System, beschrieben durch die Masse *in* des Schwingers, Dämpfungskonstante *d* (in N(m/s) und die wegabhängige Rückstellkraft (Federkonstante) *k* (in N/m). Die Auslenkung des Schwingers sei $\tilde{s}_2$. Auf den Schwinger wirken die Federkraft $f_k$, die Dämpfungskraft $f_d$ und die Beschleunigungskraft $f_b$. Wird nun zusätzlich eine äußere Kraft x angelegt, so herrscht ein Kräftegleichgewicht.

$$\tilde{x} = f_k + f_d + f_b \qquad (1)$$

Die Kräfte auf der rechten Seite von Gl. (1) (innere Kräfte) sind von der Bewegung des Schwingers, also von dessen Auslenkung $\tilde{s}_2$ und deren Ableitungen abhängig:

$$f_k = k\tilde{s}_2 \qquad (2)$$

$$f_d = d \frac{\mathrm{d}\tilde{s}_2}{\mathrm{d}t} \tag{3}$$

$$f_b = m \frac{\mathrm{d}^2\tilde{s}_2}{\mathrm{d}t^2} \tag{4}$$

Somit ist also die folgende Differenzialgleichung gültig:

$$m \frac{\mathrm{d}^2\tilde{s}_2}{\mathrm{d}t^2} = \tilde{x} - k\tilde{s}_2 - d \frac{\mathrm{d}\tilde{s}_2}{\mathrm{d}t} \tag{5}$$

Es sei nun $T$ eine (zunächst) beliebige, konstante Zeit. Definiert man nun die Variablen

$$\tilde{s}_1 = T \frac{\mathrm{d}\tilde{s}_2}{\mathrm{d}t} \tag{6}$$

$$\tilde{s}_0 = T^2 \frac{\mathrm{d}^2\tilde{s}_2}{\mathrm{d}t^2} \tag{7}$$

so geht die Differenzialgleichung über in

$$\tilde{s}_0 = \tilde{x} \frac{T^2}{m} - \tilde{s}_2 \frac{T^2 k}{m} - \tilde{s}_1 \frac{Td}{m} \tag{8}$$

mit den Zusatzbedingungen:

$$\tilde{s}_1(t) = \frac{1}{T} \int_{-\infty}^{t} \tilde{s}_0(\tau)\mathrm{d}\tau; \quad \tilde{s}_2(t) = \frac{1}{T} \int_{-\infty}^{t} \tilde{s}_1(\tau)\mathrm{d}\tau \tag{9}$$

**1.2 Blockdiagramm**

Gl. (8) lässt sich durch das in Fig. 2 gezeigte Blockdiagramm darstellen. Es repräsentiert die so genannte Zustandsvariablenform mit den Zustandsvariablen $\tilde{s}_1$ und $\tilde{s}_2$ (Ausgänge der Integratoren). In vektorieller Darstellung ergibt sich das in Fig. 3 gezeigte Blockdiagramm, hier sind die Faktoren $\tilde{A}$ und $\tilde{C}$ Matrizen:

$$\tilde{A} = \begin{bmatrix} -\frac{Td}{m} & 1 \\ -\frac{T^2 k}{m} & 0 \end{bmatrix}; \quad \tilde{C} = \begin{bmatrix} \frac{T^2}{m} & 0 \end{bmatrix}; \quad \tilde{s} = \begin{bmatrix} \tilde{s}_1 & \tilde{s}_2 \end{bmatrix} \tag{10}$$

Die zugehörige Zustandsvariablengleichung lautet:

$$\tilde{s}(t) = \frac{1}{T} \int_{-\infty}^{t} \left( \tilde{s}(\tau)\tilde{A} + \tilde{x}(\tau)\tilde{C} \right) \mathrm{d}\tau \tag{11}$$

In den Zeichnungen stellen die mit Bezugsziffer 20 gekennzeichneten Bauteile Operatoren dar, die entsprechende Eingangssignale (bzw. Zustände) mit den angegebenen Faktoren (bzw. Matrizen) multiplizieren. Die mit Bezugsziffer 21 gekennzeichneten Bauteile stellen Integratoren dar, die entsprechende Eingangssignale unter Berücksichtigung der angegebenen Faktoren integrieren. Die mit Bezugsziffer 22 gekennzeichneten Bauteile sind Verzögerungsglieder. Die mit Bezugsziffer 23 gekennzeichneten Bauteile sind Summier- bzw. Subtrahierknoten.

**1.3 Diskretisierung**

Für den Fall, dass das Eingangssignal $\tilde{x}(t)$ und die Parameter, d.h. die Elemente (in Form der Elemente der Matrizen $\tilde{A}(t)$ und $\tilde{C}(t)$) Treppenfunktionen mit einer Stufenbreite $T$ aufweisen, so lässt sich das System diskretisieren mit den diskreten Signalen

$$x(n) = \tilde{x}(nT) \tag{12}$$

$$s(n) = \tilde{s}(nT). \tag{13}$$

so dass sich das System durch das in Fig. 4 gezeigte Blockdiagramm darstellen lässt. Hierbei ist

$$A^*(n) = e^{\tilde{A}(nT)} \tag{14}$$

$$C^*(n) = \tilde{C}(nT)\left(e^{\tilde{A}(nT)} - I\right)\tilde{A}^{-1}(nT) \tag{15}$$

wobei $I$ für die Einheitsmatrix steht. Für die in Gl. (10) angegebenen Matrizen kann $A^*$ mit Gl. (50) in geschlossener Form dargestellt werden:

$$A^* = e^{-\frac{Td}{2m}}\begin{bmatrix} \cos(h) - \frac{Td}{2m}si(h) & si(h) \\ -\frac{T^2k}{m}si(h) & \cos(h) + \frac{Td}{2m}si(h) \end{bmatrix}; \quad h = T\sqrt{\frac{k}{m} - \frac{d^2}{4m^2}} \tag{16}$$

**1.4 Darstellung durch symmetrische Struktur**

Die Übergangsmatrix $A^*$ last sich gemäß den Gleichungen (40) und (41) als

$$A^* = M^{-1}A'M \tag{17}$$

mit

$$M = \begin{bmatrix} h & 0 \\ -\frac{Td}{2m} & 1 \end{bmatrix} \tag{18}$$

$$M^{-1} = \begin{bmatrix} +\frac{1}{h} & 0 \\ \frac{Td}{2mh} & 1 \end{bmatrix} \tag{19}$$

$$A' = e^{-\frac{Td}{2m}}\begin{bmatrix} \cos(h) & \sin(h) \\ -\sin(h) & \cos(h) \end{bmatrix} \qquad (20)$$

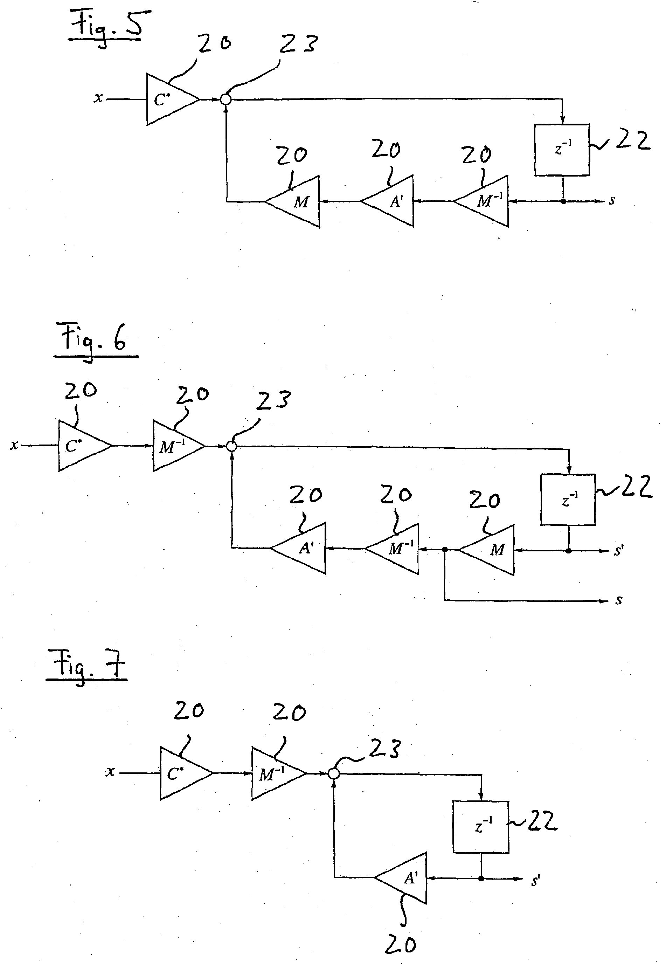

darstellen. Damit ergibt sich das in Fig. 5 gezeigte Blockdiagramm. Falls die Matrizen $A^*$, $C$ und damit $M$, $M^{-1}$ konstant sind, kann $M$ über den Summierknoten 23 und den Verzögerer 22 geschoben werden, es ergibt sich das in Fig. 6 gezeigte Blockdiagramm. Am Ausgang des Verzögerers 22 liegt nun das Signal:

$$s' = sM^{-1} \qquad (21)$$

Die Kettenschaltung $MM^{-1} = I$ kann, da sie die Einheitsmatrix repräsentiert, unterdrückt werden (Fig. 7). Dabei geht allerdings der orignale Zustandsvektor verloren. Da die Transformation Gl. (21) die zweite Komponente der Zustandsvariablen (Ortsvariable) unverändert lässt, d. h. wegen $s_2 = s_2'$, steht die Ortsvariable im symmetrischen System weiterhin zur Verfügung. Die künstlich eingeführte symmetrische Struktur hat folgende vorteilhafte Eigenschaft: Fasst man die Zustandsvariable $s' = \begin{bmatrix} s_1' & s_2' \end{bmatrix}$ als komplexe Zahl (Zeiger) $S = s_1' + js_2'$ auf, so kann die Matrixinultiplikation $A's'$ auf die Multiplikation zweier komplexer Zahlen, nämlich $As$ mit

$$\underline{A} = e^{-\frac{Td}{2m}}(\cos(h) + j\sin(h)) = e^{-\frac{Td}{2m} + Jh} \qquad (22)$$

zurückgeführt werden. Damit lässt sich der Ausschwingvorgang des Systems (für $x = 0$) folgendermaßen angeben:

$$\underline{S}(n + 1) = \underline{A}\underline{S}(n) \qquad (23)$$

Die komplexe Variable $\underline{s}$ hat zu jedem Zeitpunkt eine wohldefinierte Amplitude $|\underline{s}|$ und Pase $\varphi = arc(\underline{S})$. Insbesondere lässt sich auch die Momentanfrequenz

$$\omega = \frac{\varphi(n) - \varphi(n-1)}{T} = \frac{arc(\underline{A})}{T} \qquad (24)$$

angeben, was im Folgenden für die Analyse des zeitabhängigen Falls von Bedeutung sein wird.

### 1.5 Zeitabhängiges System und parametrische Effekte

Im Falle von zeitabhängigen Effekten, wie z. B. einer veränderlichen Resonanzfrequenz, sind die obigen Umformungen nicht zulässig. Es sei:

$$A^* = A^*(n) \qquad (25)$$

$$C^* = C^*(n) \qquad (26)$$

Dann werden nach $A'$ und $M$ zeitabhängig:

$$A' = A'(n) \qquad (27)$$

$$M = M(n) \qquad (28)$$

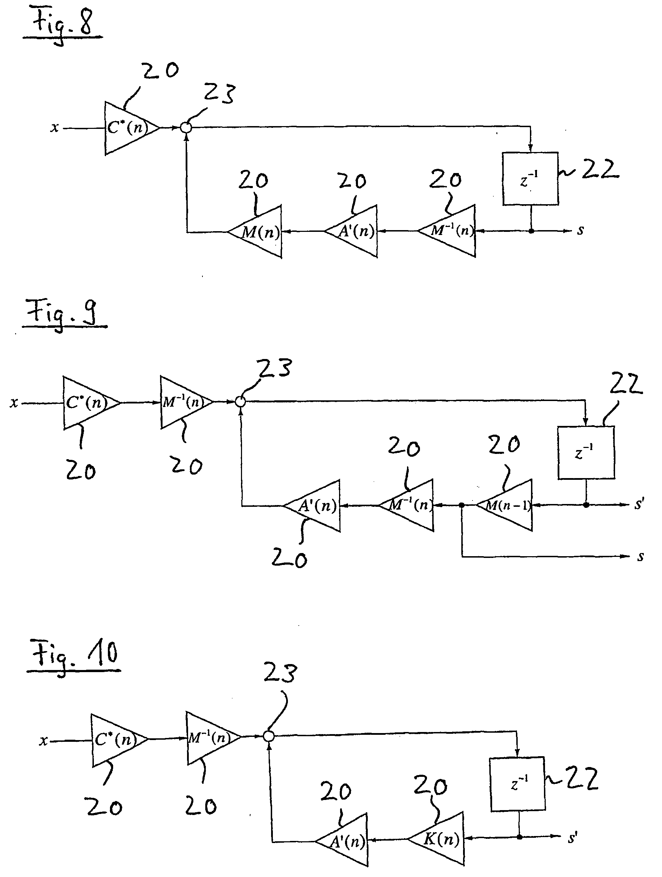

Will man nun symmetrieren, so gelangt man zunächst zu dem System in Fig. 8. Man kann auch hier die Matrix $M(n)$ über den Summierknoten 23 und den Verzögerer 22 führen. Allerdings geht hierbei $M(n)$ in $M(n\text{-}1)$ über (Fig. 9). Die Kettenschaltung $K(n) = M(n\text{-}1)M^{-1}(n)$ ergibt nun (i. a.) nicht mehr die Einheitsmatrix, so dass sich die in Fig. 10 gezeigte Struktur ergibt. Es sei nun eine Zeitabhängigkeit dadurch gegeben, dass die Federkonstante $k=k(n)$ eine Funktion der Zeit sei. Dann ergibt sich die Korrekturmatrix zu

$$K(n) = \begin{bmatrix} \dfrac{\sqrt{4k(n-1)m-d^2}}{\sqrt{4k(n)m-d^2}} & 0 \\ 0 & 1 \end{bmatrix} \tag{29}$$

Wie man sieht, ist für $k(n)=k(n\text{-}1)$ die Korrekturmatrix $K(n) = I$, wie es auch zu erwarten war.

## 2. Modulator für die Federkonstante

Der erfindungsgemäßen Einrichtung, die eine optimale Impulsfolge zur Steuerung der Federkonstanten eines Schwingers erzeugt und dabei auch eine möglichst gute Unterdrückung der parametrischen Effekte erzielt, liegen folgende Überlegungen zugrunde:

1. Die Einrichtung besitzt eine exakte Nachbildung des echten Schwingers für alle möglichen Modulationszustände (in diesem Beispiel sind es zwei Zustände.)

2. Damit kann ein virtueller Ausschwingvorgang bei gegebenem Modulationssignal simuliert werden.

3. Die Einrichtung besitzt ein Modell eines idealen Schwingers bei der gewünschten Frequenz, und kann somit dessen Zustandsvariablen nach Betrag und Phase nachbilden.

4. Die Einrichtung kann den Fehler zwischen den Zustandsvariablen der Nachbildung des echten Schwingers und den Zustandsvariablen des idealen Schwingers z. B. nach Betrag und Phase bestimmen.

5. Die Einrichtung besitzt einen Entscheider, der den nächsten Modulationszustand so auswählt, dass der Fehler zwischen den Nachbildungen des realen und des idealen Schwingers minimiert wird, indem z. B. alle Möglichkeiten in dem (den) nächsten Takt(en) vorausberechnet werden, und diejenige mit dem kleinsten Fehler ausgewählt wird.

## 2.1 Nachbildung des echten Schwingers

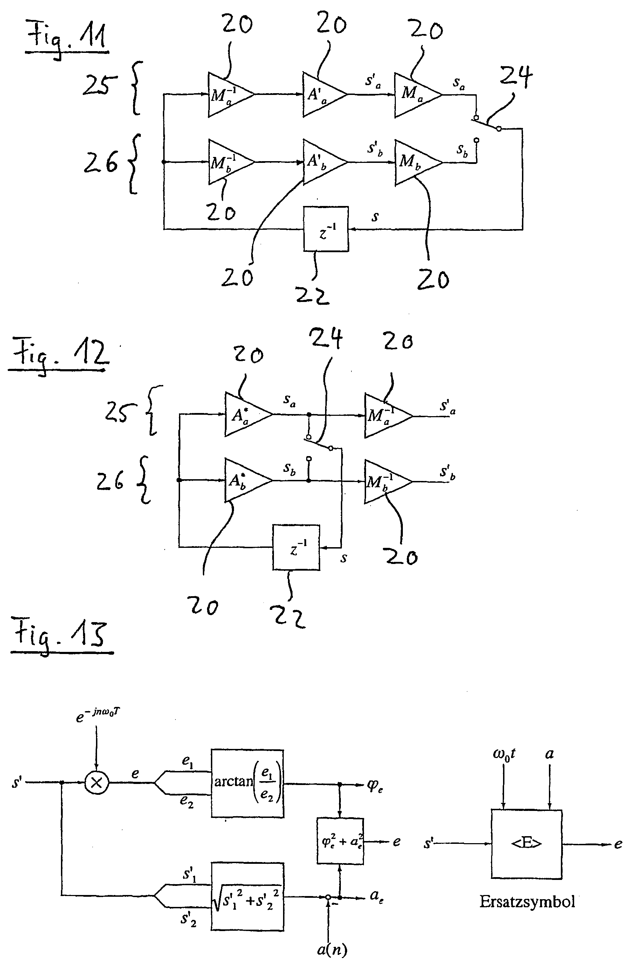

Zunächst soll gezeigt werden, wie unter Zuhilfenahme der obigen Ausführungen eine Nachbildung des echten Schwingers für den Fall (o. B. d. A.) von zwei Modulationszuständen (a und b), die zwei verschiedene Eigenfreqüenzen haben ($\omega_a$ und ($\omega_b$), hergeleitet werden kann. Die Matrizen $\tilde{A},A^*,A',M$ nehmen somit jeweils zwei Werte an, die durch die Indizes a und b bezeichnet werden, z. B. $A_a^*$, $A_b^*$. Unter Anlehnung an Fig. 5 lässt sich das Diagramm in Fig. 11 ableiten.

In Fig. 11 sind ein erster Zweig 25 und ein zweiter Zweig 26 zu sehen. Jeder Zweig erzeugt aus einem Eingangszustand $s$ einen Ausgangszustand $s_a$ (erster Zweig) oder $s_b$ (zweiter Zweig). Mittels des Schalters 24 wird einer der Ausgangszustände $s_a$ oder $s_b$ dem Verzögerer 22 zugeführt und damit im nächsten Taktzyklus wieder als neuer Eingangszustand $s$ den beiden Zweigen 25, 26 zugeführt. Jeder Zweig simuliert die Auswirkung eines Modulationssignals (repräsentiert durch $A_a^*$, $A_b^*$) auf den momentanen Schwingungszustand (repräsentiert durch den Eingangszustand $s$).

Da im Augenblick nur der Ausschwingvorgang interessiert, können das Eingangssignal $x$ und die Matrix $C$ aus der Betrachtung ausgeschlossen werden. Der Schalter wählt in Abhängigkeit vom gewünschten Modulationszustand entweder $s_a$ oder $s_b$ als gültigen Zustand $s$ aus. Die Matrizen $A_a'$ und $A_b'$ sind die Übergangsmatrizen des symmetrischen Systems, die vor- und nachgeschalteten Matrizen $M_{a,b}^{-1}, M_{a,b}$ sind die Korrekturmtatrizen, die $A_{a,b}'$ in die Übergangsmatrizen $A_{a,b}^*$ des originalen (unsymmetrischen) Systems überführen. Damit stehen die inneren Signale $S'a,b$, (das sind die Zustände, die das symmetrische System haben würde), zusätzlich zu den echten Zuständen $S_{a,b}$ zur Verfügung. Der Grund für die Bereitstellung der Zustände des symmetrischen Systems ist, dass sich diese besonders gut als Indikator für Momentanfrequenz und Moment-anamplitude eignen. Der später diskutierte Entscheider, der die nächste Schalterstellung des Schalters 24 auszuwählen hat, benötigt diese Information als Entscheidungskriterium. Man kann die Nachbildung des echten Schwingers jedoch auch direkt mit den Übergangsmatrizen $A_{a,b}^{*}$ des unsymmetrischen Systems realisieren, ohne auf die symmetrischen Zustandsvariablen verzichten zu müssen, wie Fig. 12 zeigt.

## 2.2 Bestimmung von Phasen- und Amplitudenfehler

Wie bereits erwähnt, soll die Modulation der Federkonstanten so erfolgen, dass der Ausschwingvorgang der Nachbildung des echten Schwingers in Amplitude und Phase möglichst genau einer vorgegebenen Sollfunktion folgt. Die Fig. 13 zeigt eine Einrichtung zur Bestimmung der Größe der Abweichung bei der Approximation des Einschwingvorgangs. Das Eingangssignal s' ist der Vektor der (symmetrisierten) Zustandsvariablen der Nachbildung. Hiervon wird, wobei man den Zustandsvariablenvektor als komplexen Zeiger interpretiert, die Phase der vorgegebenen Sollfunktion subtrahiert, indem man mit $e^{-jn\omega_0 t}$ multipliziert. Vom Resultat $\{e_1, e_2\}$ wird nun die Phase $\varphi_e$ bestimmt, welche die Phasenabweichung gegenüber der Vorgabe ist. Zusätzlich wird die Amplitude von s' durch Betragsbildung bestimmt. Nach Subtraktion der Amplitude $a(n)$ der Vorgabe ergibt sich die Amplitudenabweichung $a_e$. Aus Phasen- und Amplitudenabweichung lässt sich schließlich ein Gesamtfehler e ableiten, indem z. B. die Quadratsumme der beiden Abweichungen gebildet wird. Rechts in der Fig. ist eine vereinfachte symbolische Darstellung <E> der Anordnung gezeigt.

Das Modul <E> kann demnach als Vergleichseinheit angesehen werden, durch die eine Approximation für die Abweichung zwischen dem momentanen Sollwert und dem momentanen tatsächlichen Wert der zu regelnden Resonanzfrequenz des realen Schwingers ermittelbar ist. Das Modul <E> kann ferner als Vergleichseinheit angesehen werden, durch die ein exakter Wert (genau genommen eine Summation zweier exakter Werte) für die Abweichung zwischen dem momentanen Sollwert und dem momentanen tatsächlichen Wert der zu regelnden Resonanzfrequenz des in der Simulation nachgebildeten Schwingers ermittelbar ist.

Die Art und Weise der Ermittlung des Gesamtfehlers e aus den Eingangssignalen des Moduls <E>, d.h. die Funktionsweise des Moduls <E>, kann auch anderweitig realisiert werden; Es können andere Gesamtfehler-Kriterien verwendet werden. Beispielsweise ist es möglich, die Differenz zwischen $s'(n)$ und dem Vorgabesignal $Ae^{jn\omega_0 t}$ zu bilden, und hieraus beispielsweise den Betrag oder dessen Quadrat zu bilden (die Signale werden als komplex aufgefasst): $e = |s'(n) - Ae^{jn\omega_0 t}|$ oder $e = |s'(n) - Ae^{jn\omega_0 t}|^2$.

## 2.3 Entscheider für die Modulationseinrichtung

Um das Modulationssignal für die Federkonstante bestimmen zu können, d. h., die Stellung des Schaltes in der Nachbildung für den nächsten Takt angeben zu können, werden die beiden möglichen zukünftigen symmetrisierten Zustände $s_a'$ und $s_b'$ mit zwei Blöcken <E> bezüglich des Fehlers gegenüber dem Vorgabesignal ausgewertet. Ein nachgeschalteter Entscheider 27 vergleicht die beiden Fehler $e_a$ und $e_b$ und wählt als nächste Schalterstellung diejenige aus, die den Zustand mit dem kleineren Fehler abgreift. Ein Referenzgenerator 28 für Phase und Amplitude, dessen Frequenz $\omega_0$ eingestellt werden kann, erzeugt die Referenzphase $n\omega_0 T$ und die Referenzamplitude $a(n)$, die den Werten des idealen Schwingers entsprechen. $a(n)$ ist eine exponentiell abklingende Funktion mit einer Zeitkonstanten, die von der Güte des idealen Schwingers abhängt, d. h., $\alpha = a(n)/a(n+1) > 1$ ist ein konstanter Wert. Die dargestellte Anordnung steuert nun den Schalter so, dass der Ausschwingvorgang der Nachbildung in Betrag und Phase der Vorgabe im Mittel folgt. Demnach kann die Federkonstante des echten Schwingers mit dem von dem Entscheider erzeugten Modulationssignal gesteuert werden, was dazu führt, dass dieser echte geschaltete Schwinger einen idealen nichtgeschalteten Schwinger mit der Resonanzfrequenz $\omega_0$ nachbildet.

Das vorgestellte System hat zwei Mängel. Einer ist praktischer, der andere prinzipieller Natur. Der praktische Mangel hängt damit zusammen, dass die Amplitude des Signals der Nachbildung, die ja der Amplitude des Vorgabesingals folgt, eine exponentiell abklingende Funktion ist. Damit weren die Signale immer kleiner, bis wegen auftretender numerische Probleme keine korrekte Funktion mehr möglich ist. Dieses Problem kann behoben werden, indem man die betreffenden Signale mit dem Kehrwert der abklingenden Exponentialfunktion multipliziert. Das erzeugte Modulationssignal bleibt hierbei gleich. Das wird erreicht, indem man die Übergangsmatrizen $A_a^{*}$ und $A_b^{*}$ mit dem oben definierten Faktor $\alpha$ multipliziert. Hierbei wird die Nachbildung entdämpft. Die Vorgabeamplitude wird dann konstant $a(n) = 1$ und braucht demnach nicht mehr vom Referenzgenerator erzeugt zu werden. Man beachte, dass der hiermit gesteuerte echte physikalische Schwinger dadurch nicht entdämpft wird, da ja das Modulationssignal von der Maßnahme unbeeinflusst bleibt. Die Maßnahme soll nur den numerisch stabilen kontiuierlichen Betrieb des Modulationssignalgenerators sicherstellen.

Man kann die Matrizen auch direkt aus dem entdämpften System ($d = 0$) bestimmen; dadurch entfällt der Faktor α. Aufgrund der Entdämpfung der Nachbildung ergeben sich vereinfachte Gleichungen für die Matrizen A* und $M^{-1}$. Wegen $d=0$ wird nun

$$h = \omega T; \quad \omega = \sqrt{\frac{k}{m}} \tag{30}$$

Hierbei ist $\omega$ die momentane Resonanzfrquenz der Nachbildung. Damit wird

$$\tilde{A} = \begin{bmatrix} 0 & 1 \\ -\omega^2 T^2 & 0 \end{bmatrix} \tag{31}$$

$$A^* = \begin{bmatrix} \cos(\omega T) & \frac{\sin(\omega T)}{\omega T} \\ -\omega T \sin(\omega T) & \cos \omega T \end{bmatrix} \tag{32}$$

$$M^{-1} = \begin{bmatrix} -\frac{1}{\omega T} & 0 \\ 0 & 1 \end{bmatrix} \tag{33}$$

Die Matrizen $A_a^*$, $A_b^*$ sowie $M_a^{-1}$, $M_b^{-1}$ ergeben sich aus $A^*$ und $M^{-1}$, indem man dort $\omega$ durch $\omega_a$, $\omega_b$ ersetzt.

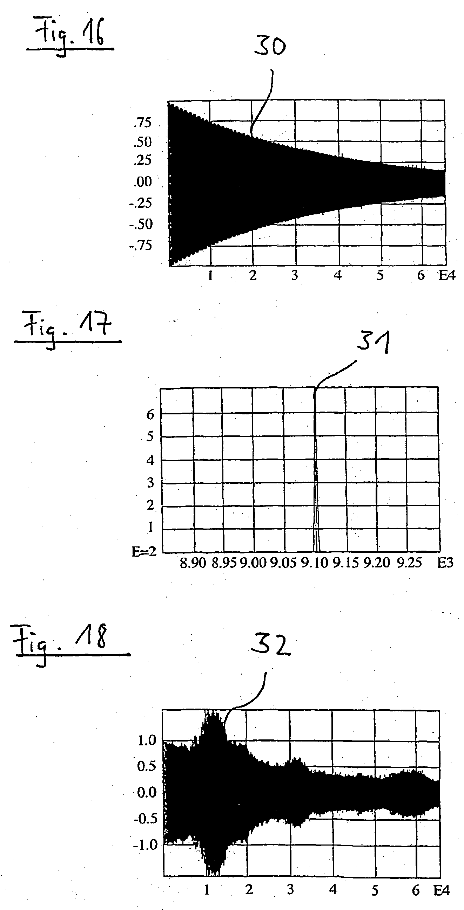

Es soll nun zunächst das Resultat einer Simulation mit dem vorgestellten System diskutiert werden. Die Verhältnisse sind so gewählt, dass der reale, physikalische Schwinger mittels der schaltbaren Federkonstanten auf eine Eigenresonanz von 9000 Hz oder 9200 geschaltet werden kann. Für die Simulation wurde eine Frequenzvorgabe von 9100 Hz gewählt. Die Anfangsbedingungen wurden so gewählt, dass die Phasen von realem Schwinger und Nachbildung gleich waren. Der reale Schwinger wurde dann sich selbst überlassen; der zugehörige Ausschwingvorgang 30 ist in Fig. 16 dargestellt. Wie man sieht, ergibt sich ein schöner, exponentieller Ausschwingvorgang, und wenn man diese Funktion einer Fourier-transformation unterzieht, so ergibt sich eine scharfe Resonanzspitze 31 bei 9100 Hz (Fig. 17). Wiederholt man jedoch die Simulation und startet den realen Schwinger nicht in Phase mit dem in der Nachbildung simulierten Einschwingvorgang, so ergibt sich, wie in Fig. 18 ersichtlich, ein unkontrollierter Verlauf 32 der Hüllkurve. Damit wird deutlich, dass es nicht genügt, den simulierten Ausschwingvorgang in nur einer Phasenlage ablaufen zu lassen.

**2.4 Simultane Nachbildung des Ausschwingvorgangs in zwei um $\pi/2$ versetzten Phasenlagen.**

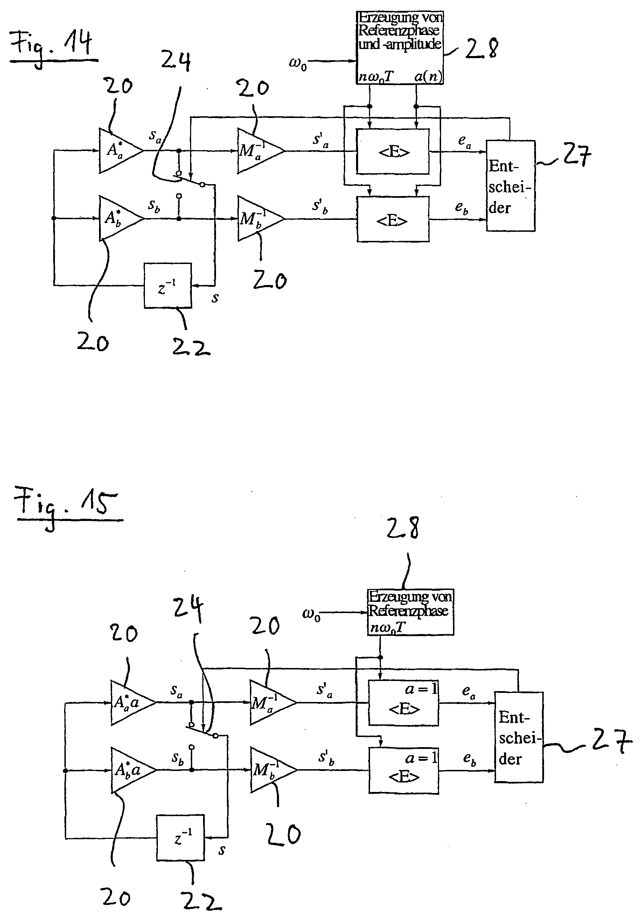

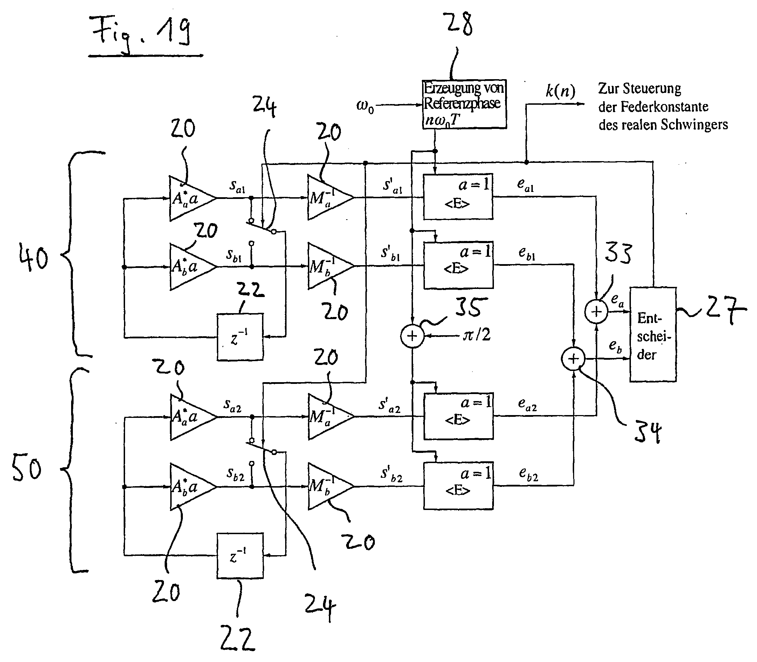

Den angesprochenen Mangel kann man beseitigen, wenn man zur Erzeugung des Modulationssignals zwei Nachbildungen vorsieht, in denen zwei in der Phase um $\pi/2$ verschobene Einschwingvorgänge ablaufen, wobei deren Phasen und Amplituden gleichzeitig überwacht und kontrolliert werden, indem ein summarisches Fehlerkriterium für den Entscheider vorgesehen wird (Fig. 19). Wie man sieht, ist die Nachbildung (das in Fig. 15 gezeigt System) zweimal vohanden, desgleichen die paarweisen Fehlerauswertemodule <E>. Die erste Nachbildung ist hierbei mit Bezugsziffer 40, die zweite Nachbildung mit Bezugsziffer 50 gekennzeichnet. Für die untere Nachbildung wird für die Phasenvorgabe ein konstanter Wert von $\pi/2$ addiert, so dass deren Ausschwingvorgang immer mit dieser Phasenverschiebung läuft. Für den Entscheider müssen nun die jeweiligen Fehler in den Schaltzuständen a und b kombiniert werden, indem sie z. B. einfach addiert werden. Wenn man mit dieser Anordnung nun die Federkonstante des realen Schwingers steuert, so läuft dessen Ausschwingvorgang in jeder Phasenlage korrekt ab, wie durch Simulation nachgewiesen werden kann. Das Signal k(n) kann zur Steuerung des Pulsmodulators verwendet werden.

Mit anderen Worten: simultan werden zwei Schwingungsantworten des Resonators, die aus der Beaufschlagung des Sensors mit einer Modulationssignal-Folge resultieren, simuliert, wobei für jede der Schwingungsariltworten gleichzeitig Amplitude und Phase der Schwingungsantwort auf bestimmte Sollwerte/Sollwertverläufe geregelt werden, und die Sollphase der einen Schwingungsantwort gegenüber der Sollphase der anderen Schwingungsantwort um die Phase $\pi/2$ verschoben ist. Das Verschieben der Sollphase wird durch den Summierknoten 35 erreicht. Für jedes erzeugbare Modulationssignal wird den beiden Simulationen jeweils eine effektive Gesamtabweichung (in der ersten Nachbildung: ea1 für das erste Modulationssignal, und eb1 für das zweite Modulationssignal; in der zweiten Nachbildung: ea2 für das erste Modulationssignal, und eb2) zugeordnet, die gegeben ist aus der Summe der Abweichungen (Summe aus ea1 und ea2 bzw. aus eb1 und eb2 für das zweite Modulationssignal) zwischen den momentanen Sollwerten der Simulation und entsprechenden in der Simulation geregelten Werten, die aus dem Beibehalten des Modulationssignals beziehungsweise dem Überwechseln in das Modulationssignal resultieren würde. Dann werden die effektiven Gesamtabweichungen bezüglich desselben Modulationssignals aus beiden Simulationen addiert (über die Summierknoten 33 und 34), womit sich die Summen $e_a$ und $e_b$ ergeben. Es wird das Modulationssignal ausgewählt, für das die im vorangehenden Schritt berechnete Summe ($e_a$ oder $e_b$) am geringsten ist.

Wesentliche Aspekte der Erfindung seien nochmals kurz zusammengefasst: Bei mikromechanischen Systemen ist es häufig wünschenswert, die Eigenfrequenz eines Schwingers elektrisch durch die Steuerung einer elektrostatischen Feder abzustimmen. Aufgrund hoher Anforderungen an den Miniaturisierungsgrad und den Leistungsverbrauch ist es wünschenswert, auf eine analoge Steuerung mit dem hierbei notwendigen DA-Wandler zu verzichten. Als Alternative bietet sich ein digitales Pulsmodulationsverfahren an, bei dem die Impulse, die die elektrostatische Federkonstante zwischen zwei Extremwerten umschalten, in geeigneter Weise zeitlich verteilt werden. Eine Analyse zeigt, dass es nicht genügt, eine einfache Verteilungsmethode zu verweden, die dafür sorgt, dass die mittlere Häufigkeit der Impulse der relativenLage der gewünschten Frequenz innerhalb der Extremwerte entspricht. Zur Lösung wird ein Verfahren vorgeschlagen, bei dem ein simulierter Ausschwingvorgang einer Nachbildung möglichst genau dem geforderten Ausschwingvorgang des realen Schwingers bei der gegebenen Güte und Frequenz folgt. Der freie Parameter dieser Approximation ist die gesuchte Impulsfolge, die durch den Approximationsprozess erzeugt wird. Es ist gezeigt worden, dass es nötig ist, die Approximation des Ausschwingvorgangs simultan durch zwei Nachbildungen mit zwei um $\pi/2$ versetzten Phasenlagen vorzunehmen. Es ist ebenfalls gezeigt worden, dass man, ohne das Ergebnis zu ändern, zu entdämpften Systemen für die Nachbildungen übergehen kann, wobei ein kontinuierlicher Betrieb des Pulsmodulators ermöglicht wird. Die hierbei erzeugten Impulse steuern in der angegebenen Weise die elektrostatische Feder(n) des realen Schwingers, dessen Resonanzfrequenz sich dann in der gewünschten Weise einstellen lässt. Parametrische Effekte werden wirksam unterdrückt.

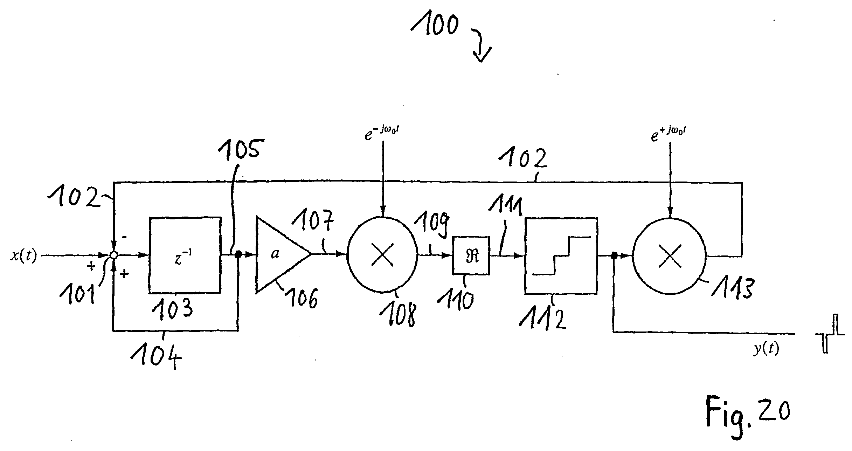

In der vorangehenden Beschreibung wurde das erindungsgemäße "Prinzip des Durchspielens aller Möglichkeiten" (das aufgrund der endlichen Kombinationsmöglichkeit diskreter Impulse möglich wird) anhand der Regelung der Resonanzfrequenz verdeutlicht. In der folgenden Beschreibung soll erörtert werden, wie dieses Prinzip auch zur Regelung der Anregungsschwingung/Ausleseschwingung herangezogen werden kann. Dazu sei zunächst unter Bezugnahme auf Fig. 20 beispielhaft darauf eingegangen, wie Anregungsschwingung/Ausleseschwingung ohne Anwendung des Durchspielsprinzips geregelt werden können.

Fig. 20 zeigt eine komplexe Darstellung einer möglichen Ausführungsform 100 eines Pulsmodulators.

Das komplexe Eingangssignal $x(t)$ umfasst einen Realteil sowie einen Imaginärteil, welche beide als digitale Werte repräsentiert werden. Im Addiererknoten 101 wird von dem komplexen Eingangssignal $x(t)$ das komplexe Rückkopplungssignal 102 subtrahiert, wobei die Differenz dieser beiden komplexen Signale die Regelabweichung darstellt. Außerdem wird im Addiererknoten 101 der (ebenfalls komplexe) Inhalt des Verzögerungsglieds 103 zu dieser Differenz dazu addiert. Der Inhalt des Verzögerungsglieds 103 wird über die Signalleitung 104 zum Addiererknoten 101 geführt. Das Verzögerungsglied 103 bildet mit der Signalleitung 104 zusammen eine komplexe Integratorstufe, welche die komplexe Regelabweichung, also die Differenz von Eingangssignal und Rückkopplungssignal aufintegriert. Das aufintegrierte Signal 105 wird in der Verstärkerstufe 106 entsprechend dem Faktor "a" verstärkt, und das verstärkte Signal 107 wird der ersten Multipliziererstufe 108 zugeführt. Dort wird das verstärkte Signal 107 mit dem komplexen Mischsignal $e^{-j\omega_0 t}$ multipliziert, um so das auf die Frequenz $\omega_0$ heraufgemischte Signal 109 zu erhalten. Der Block 110 ermittelt den Realteil des komplexen heraufgemischten Signals 109, und der so erhaltene Realteil 111 des heraufgemischten Signals wird dem Quantisierer 112 zur Verfügung gestellt.

Bei der in Fig. 20 gezeigten Ausführungsform ist der Quantisierer 112 als ternärer Quantisierer ausgeführt, welcher das jeweilige Eingangssignal mit Hilfe von Komparatoren in die drei möglichen Werte -1, 0, +1 eines Pulssignals umsetzt. Das auf diese Weise erzeugte quantisierte Pulssignal y(t) kann am Ausgang des Quantisierer 112 abgegriffen werden. Zur Erzeugung des komplexen Rückkopplungssignals 102 wird das reellwertige Pulssignal y(t) in der zweiten Multipliziererstufe 113 mit dem konjugiert komplexen Mischsignal $e^{+j\omega_0 t}$ multipliziert. Das auf diese Weise durch Multiplikation einer reellen und einer komplexen Zahl erhaltene komplexe Rückkopplungssignal 102 wird dem Addiererknoten 101 am Eingang der Schaltung zugeführt.

Auf diese Art und Weise wird aus dem komplexen Kompensationssignal $x(t)$eine entsprechende Modulationssignalfolge erzeugt (Pulssignal $y(t)$, entspricht den Signalen S1 und S2 in Fig. 1), die die Ausleseschwingung des Resonators R zurückstellt oder eine Anregung der Anregungsschwingung des Resonators R bewirkt.

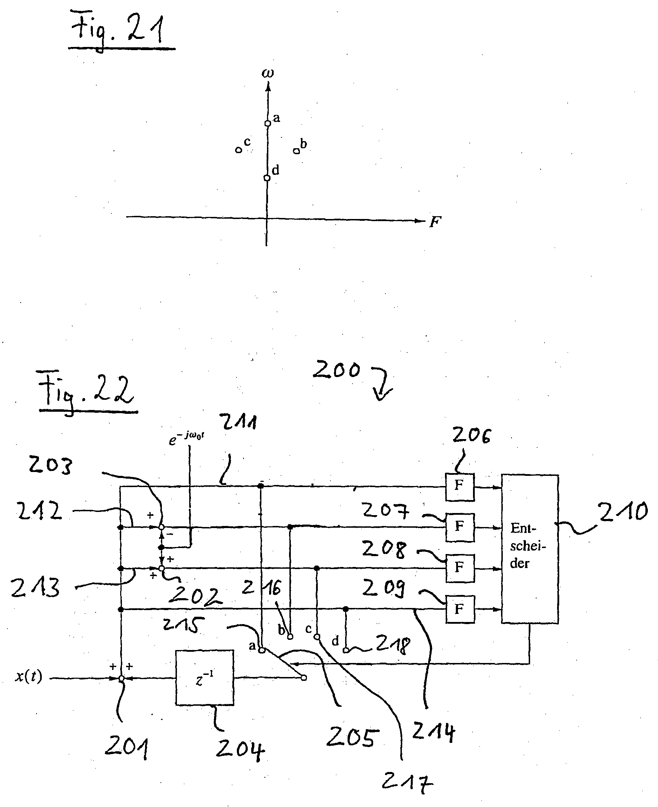

Der Pulsmodulator 100 weist den Nachteil auf, dass das durch den Pulsmodulator 100 benutzte Quantisierungsverfahren nicht dazu geeignet ist, mit Verfahren zur Regelung anderer physikalischer Größen (z. B. einem Verfahren zur Regelung der Resonanzfrequenz eines Resonators) kombiniert zu werden. Diese Nachteile können vermieden werden, wenn anstelle des in Fig. 20 gezeigten Pulsmodulators 100 der in Fig. 22 gezeigte Pulsmodulator 200 eingesetzt wird. Dies wird in der folgenden Beschreibung erörtert.

Es sei ein (mikromechanischer) Resonator gegeben, der eine bewegliche Elektrode aufweist, die symmetrisch zu zwei Steuerelektroden $E_1$ und $E_2$ angeordnet ist. Durch Anlegen einer elektrischen Spannung an die Steuerelektroden ist es einerseits möglich, eine Kraft auf die bewegliche Elektrode und damit den Resonator aufzuprägen, andererseits lässt sich durch die Steuerelektroden auch die Resonanzfrequenz des Schwingers beeinflussen. Es sei angenommen, dass an den Steuerelektroden entweder eine Spannung 0 oder $U_0$ anliegt. Die hierbei möglichen vier Kombination aus Kräften und Resonanzfrequenzen sind in der folgenden Tabelle angegeben (siehe hierzu auch Fig. 21):

| Modulations-Zustand/Modulationssignal | $E_1$ | $E_2$ | Kraft | Frequenz |
|---|---|---|---|---|
| a | 0 | 0 | 0 | $\omega_a$ |
| b | 0 | $U_0$ | $F_0$ | $\omega_b$ |
| c | $U_0$ | 0 | $-F_0$ | $\omega_c$ |
| d | $U_0$ | $U_0$ | 0 | $\omega_d$ |

Hierbei gilt in der Regel bei völliger Symmetrie $\omega_a < \omega_b = \omega_c > \omega_d$.

Die in der obigen Tabelle angegebenen Kräfte $F \in \{-F_0, 0, F_0\}$ implizieren eine ternäre Anregung, d.h. die Verwendung eines Pulsmodulators, dessen Ausgangssignale ternär quantisiert sind. Zur Regelung der Amplituden/Phasen der Anregungsschwingung/Ausleseschwingung des Resonators ließe sich damit der in Fig. 20 gezeigte Pulsmodulator prinzipell einsetzen. Wie jedoch bereits angedeutet wurde, muss dieser, wenn mehrere physikalische Größen gleichzeitig geregelt werden sollen, modifiziert werden. Erfindungsgemäß wird zur gleichzeitigen Regelung von Anregungsschwingung-/Ausleseschwingung und Resonanzfrequenz über dieselben Steuerelektroden anstelle des Quantisierers 112 in Fig. 20 ein Entscheider eingesetzt, der auf Basis eines Fehlerkriteriums operiert.

In Fig. 22 ist eine bevorzugte Ausführungsform einer entsprechenden Regelungseinheit 200 gezeigt, die anstelle des Pulsmodulators 100 zur Regelung der Amplitude und Phase der Anregungsschwingung-/Ausleseschwingung des Resonators dienen könnte.

Die Regelungseinheit 200 weist einen ersten Summierknoten 201, einen zweiten Summierknoten 202, einen dritten Summierknoten 203, ein Verzögerungsglied 204, ein Schaltelement 205, einen ersten bis vierten Fehlerblock 206 bis 209 sowie einen Entscheider 210 auf.

Ein wesentlicher Unterschied gegenüber dem in Fig. 20 gezeigten Pulsmodulator 100 ist, dass anstelle des dort verwendeten Quantisierers 112 der Entscheider 210 eingesetzt wird. Das Eingangssignal $x(t)$ wird zunächst auf Signalleitungen 211 bis 214 gelegt, wobei auf das Signal $x(t)$ im Summierknoten 202 das Signal $e^{-j\omega_0 t}$ aufaddiert wird und vom Signal $x(t)$ im Summierknoten 203 das Signal $e^{-j\omega_0 t}$ abgezogen wird. Entsprechend modifizierte/unveränderte Signale werden den Fehlerblöcken 206 bis 209 zugeführt, die die Abweichung der ihnen zugeführten Signale vom momentanen Sollwert des Eingangssignal $x(t)$ ermitteln bzw. die ihnen zugeführten Signale so umwandeln, dass entsprechende Abweichungen durch den Entscheider 210 festgestellt werden können. Entsprechende Fehlersignale (Ausgangssignale der Fehlerblöcke 206 bis 209) werden dem Entscheider 210 zugeführt, der durch Auswerten der Fehlersignale entscheidet, welches Eingangssignal der Fehlerblöcke 206 bis 209 die geringste Abweichung vom momentanen Sollwert aufweist, und das Schaltelement 205 so steuert, dass das Eingangssignal des entsprechenden Fehlerblocks, für das die ermittelte Abweichung die geringste ist, an den Eingang des Verzögerungsglieds 204 angelegt wird (eines der an den Abgriffen 215 bis 218 anliegenden Signale). Das auf diese Weise im momentanen Taktzyklus in das Verzögerungsglied 204 eingespeicherte Signal wird im nächsten Taktzyklus dem Knoten 201 zugeführt, der das Signal auf das Eingängssignal $x(t)$ addiert. Jeder der Abgriffe 215 bis 218 entspricht einem in obiger Tabelle angeführten Modulationszustand/Modulationssignal a), b), c) und d). D. h., bei Verbinden des Abgriffs 216 mit dem Eingang des Verzögerungsglieds 204 wird der Resonator R mit dem Modulationssignal b) beaufschlagt (d.h es liegt die Kraft $F_0$ an den Steuerelektroden an), bei Verbinden des Abgriffs 217 mit dein Eingang des Verzögerungsglieds 204 wird der Resonator R mit dem Modulationssignal c) beaufschlagt (d.h es liegt die Kraft $-F_0$ an den Steuerelektroden an), etc.

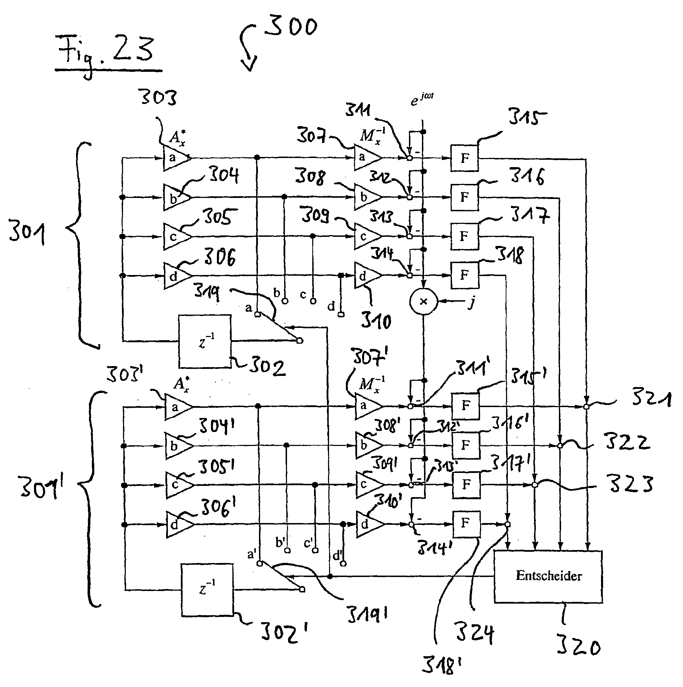

Die Funktionsweisen der in den Fig. 20 und 23 gezeigten Regelungseinheiten 100, 200 ähneln einander. In beiden Regelungseinheiten wird ein integrierter Fehler zwischen dem komplexen Vorgabesignal (Eingangssignal) $x(t)$ und dem (um $-\omega_0$) heruntergemischten Modulationssignal minimiert. In Fig. 20 wird hierzu der Fehler wieder heraufgemischt und ternär quantisiert, wobei der Quantisierer 112 den Modulationszustand bestimmt. Hierdurch entsteht ein geschlossener Regelkreis, der den integrierten Fehler minimiert. In Fig. 23 werden hingegen zu einem bestimmten Zeitpunkt alle möglichen Modulationszustände a) bis d) durchprobiert und hinsichtlich des jeweils dabei auftretenden integrierten Fehlers analysiert. Für die Zustände a) und d) ist in dieser Ausführungsform das Modulationssignal (genauer: die Kraft) Null, daher bleibt der integrierte Fehler (bis auf $x(t)$) unverändert, während in den Zuständen b) und c) das heruntergemischte Modulationssignal subtrahiert/addiert wird. Für alle Modulationszustände a) bis d) wird der komplexe integrierte Fehler durch Fehlerblöcke 206 bis 214 ausgewertet. Der Entscheider 210 findet somit den optimalen Modulationszustand a), b), c) oder d) und stellt das Schaltelement 205 in die entsprechende Position, so dass die Integration des Fehlers je nach ausgewähltem Modulationszustand mit einem der an den Abgriffen 215 bis 218 anliegenden Signale erfolgen kann. Gleichzeitig wird das entsprechende Modulationssignal gemäß der Tabelle durch eine Impulserzeugungseinheit erzeugt (hier nicht gezeigt), die durch den Entscheider 210 angesteuert wird, und an den Resonator angelegt. Die Signale können zweidimensionale bzw. komplexe Signale sein. Die Fehlerblöcke 206 bis 214 bilden beispielsweise das Quadrat des Absolutwerts ihres Eingangssignals und geben entsprechende Signale an den Entscheider 210 weiter.

In der vorangehenden Beschreibung ist ein Verfahren zur Anregung eines mechanischen Schwingers mit digitalen Impulsen vorgestellt worden. Weiterhin wurde gezeigt, wie sich die Resonanzfrequenz eines solchen Schwingers durch digitale Impulse an speziellen Elektroden, die eine elektrostatische Federkonstante steuern, abstimmen lässt. In der folgenden Beschreibung wird gezeigt, wie sich beide Verfahren zusammenfassen lassen, d.h., wie sich die Regelung der Resonanzfrequenz des Resonators mit der Anregung/Kompensation von Schwingungen des Resonators unter Verwendung von nur zwei Elektroden kombinieren lässt.

In der vorangehenden Beschreibung ist bereits ein Verfahren beschrieben worden, das ein Steuersignal für eine schaltbare Federkonstante zur Verfügung stellt, so dass ein aus einer Masse und einer schaltbaren Feder zusammengesetzter Resonator möglichst genau einen Resonator mit einer vorgegebenen Resonanzfrequenz approximiert. Fig. 19 ist ein Regelungssystem gezeigt, das zwischen zwei Resonanzfrequenzen schalten kann. Da in der in Figur 22 gezeigten Regelungseinheit 200 im Falle von $\omega_b = \omega_c$ zwischen drei verschiedene Resonanzfrequenzen, im Falle von $\omega_b \neq \omega_c$ sogar zwischen vier Resonanzfrequenzen zu schalten ist (siehe Tabelle oben). muss das in Fig. 19 gezeigte Regelungssystem entsprechend erweitert werden, wenn das in Fig. 19 gezeigte Regelungssystem mit dem in Fig. 22 gezeigten Regelungssystem kombiniert werden soll.

Eine mögliche Lösung stellt die in Fig. 23 gezeigte Regelungseinheit 300 dar: Die Regelungseinheit 300 weist einen ersten Zweig 301 und einen zweiten Zweig 301' auf. Der erste Zweig 301 weist ein Verzögerungsglied 302, einen ersten bis vierten Operator 303 bis 306, einen fünften bis achten Operator 307 bis 310, einen ersten bis vierten Subtrahierknoten 311 bis 314, einen ersten bis vierten Fehlerblock 315 bis 318, und ein Schaltelement 319 auf. Analog hierzu weist der zweite Zweig 301 ein Verzögerungsglied 302', einen ersten bis vierten Operator 303' bis 306', einen fünften bis achten Operator 307' bis 310', einen ersten bis vierten Subtrahierknoten 311' bis 314', einen ersten bis vierten Fehlerblock 315' bis 318', und ein Schaltelement 319' auf.

Es sei angenommen, dass das Ausgangssignal des Verzögerungsglieds 302 den momentanen Zustand des simulierten Schwingungsprozesses des Resonators repräsentiert. Das Ausgangssignal wird den Eingängen der Operatoren 303 bis 306 zugeführt, wobei jeder Operator den Einfluss eines der vier erzeugbaren Modulationssignale auf den momentanen Zustand der Schwingungssimulation simuliert. Die Ausgangssignale der Operatoren 303 bis 306 werden mittels der Operatoren 307 bis 310 in eine für die Fehlerauswertung geeignete Form transformiert, von jedem der transformierten Signale das Signal $e^{-j\omega_0 t}$ abgezogen (an den Summierknoten 311 bis 314) und die so erhaltenen Signale den Fehlerblöcken 315 bis 318 zugeführt. Die Fehlerblöcke 315 bis 318 ermitteln die Abweichung bzw. ein Maß für die Abweichung der durch die Operatoren 303 bis 306 erzeugten Ausgangssignale von dem momentanen Sollwert ($e^{-j\omega_0 t}$) und geben entsprechende Abweichungssignale an Addierknoten 321 bis 324 weiter. Die Buchstaben a), b), c) und d) kennzeichnen hierbei den jeweiligen in obiger Tabelle angegebenen Modulationszustand, dessen Einfluss auf den Resonator getestet werden soll.

Die Funktionsweise des zweiten Zweigs 301' entspricht der Funktionsweise des ersten Zweigs 301. Die in dem zweiten Zweig 301' durch die Fehlerblöcke 315' bis 318' ermittelten Abweichungssignale werden ebenfalls an die Addierknoten 321 bis 324 weitergegeben. In jedem Addierknoten 321 bis 324 wird ein durch den ersten Zweig 301 erzeugtes Abweichungssignal zu einem Abweichungssignal, das durch den zweiten Zweig 301' erzeugt wurde, addiert, wobei in jedem Addierknoten Abweichungssignale bezüglich des gleichen Modulationssignals (Modulationszustands) addiert werden. Die addierten Abweichungssignale werden dem Entscheider 320 zugeführt.

Die beiden Zweige 301 und 301' unterscheiden sich lediglich dadurch, dass das Signal, das in den Subtrahierknoten 311 bis 314 abgezogen wird, gegenüber dem Signal, das in den Subtrahierknoten 311' bis 314' abgezogen wird, eine Phasenverschiebung von vorzugsweise $\pi/2$ aufweist. Der Entscheider 320 steuert die Schaltelemente 319 und 319' simultan und in der Weise, dass dasjenige Ausgangssignal der Operatoren 303 bis 306 bzw. 303' bis 306' an den Eingang des Verzögerungsglieds 302 bzw. 302' angelegt wird, dessen zugehöriges Abweichungssignal, summiert mit dem entsprechenden Abweichungssignal des jeweils anderen Zweigs, bezüglich Amplitude und Phase die geringste Abweichung gegenüber dem momentanen Sollwert ($e^{-j\omega_0 t}$) aufweist. $\omega_0$ stellt hierbei die Resonanzfrequenz dar, auf die der Resonator geregelt werden soll.

Bei Verbinden des Abgriffs 331/331') mit dem Eingang des Verzögerungsglieds 302/302' wird der Resonator R mit dem Modulationssignal b) beaufschlagt (d.h es liegt die Kraft $F_0$ an den Steuerelektroden an), bei Verbinden des Abgriffs 332)/332') mit dem Eingang des Verzögerungsglieds 302/302' wird der Resonator R mit dem Modulationssignal c) beaufschlagt (d.h es liegt die Kraft $-F_0$ an den Steuerelektroden an), etc..

Es werden also simultan zwei Eigenschwingungsvorgänge des Resonators simuliert (in jedem der Zweige 301, 301' wird ein Eigenschwingungsvorgang simuliert), wobei jeder Eigenschwingungsvorgang bezüglich Amplitude und Phase mit jeweiligen Sollwerten/Sollwertverläufen ($e^{j\omega_0 t}$) verglichen wird, und die Sollphase des einen Eigenschwingungsvorgangs gegenüber der Sollphase des anderen Eigenschwingungsvorgangs um die Phase $\pi/2$ verschoben ist, wobei

- für jedes erzeugbare Modulationssignal den beiden Simulationen jeweils eine Gesamtabweichung zugeordnet wird (Abweichungssignal, das durch die Fehlerblöcke 315-318 bzw. 315'-318' erzeugt wird), die gegeben ist aus der Summe der Abweichungen zwischen den momentanen Sollwerten und entsprechenden Simulationswerten für Amplitude und Phase, die aus dem Beibehalten dieses Modulationssignals beziehungsweise dem Überwechseln in dieses Modulationssignal resultieren würden,

- die Gesamtabweichungen bezüglich desselben Modulationssignals aus beiden Simulationen addiert werden (in den Addierknoten 321 bis 324), wobei der Entscheider 320 bewirkt, dass der Resonator mit demjenigen Modulationssignal (a), b), c) oder d)) beaufschlagt wird, für das die entsprechende Gesamtabweichungs-Summe zur besten Approximation des Sollwertverlaufs führt.

In den beiden rückgekoppelten Zweigen 301, 301' wird dabei vorzugsweise ein entdämpften System simuliert. Es wird ein Referenzträger $e^{j\omega t}$ bereitgestellt, der die Vorgabe für den Einschwingvorgang in der oberen Schleife ist. Für die untere Schleife wird der Referenzträger noch mit $j$ multipliziert, so dass eine Phasenverschiebung von $\pi/2$ entsteht. Die Matrizen $A_x^*$, $M_x^{-1}$, $x=a,b,c,d$, sind von der Form:

$$A_x^* = \begin{bmatrix} \cos(\omega_x t) & \sin(\omega_x t)/(\omega_x t) \\ -\omega_x t \sin(\omega_x t) & \cos(\omega_x t) \end{bmatrix}; \quad M_x^{-1} = \begin{bmatrix} -1/\omega_x t & 0 \\ 0 & 1 \end{bmatrix}$$

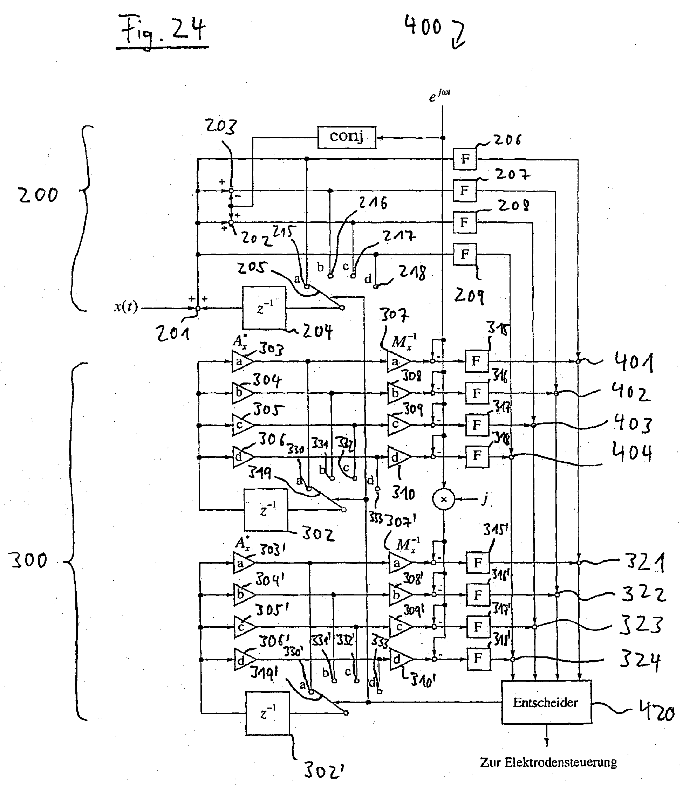

In Fig. 24 ist eine Regeleinrichtung 400 gezeigt, in der die Regeleinheiten 200 und 300 aus Fig. 22 und 23 miteinander zu einer Einheit kombiniert sind, durch die gleichzeitig die Resonanzfrequenz $\omega$ als auch die Amplitude/Phase der Anregungsschwingung/Ausleseschwingung der Resonators auf bestimmte Werte regelbar sind.

In der Regeleinrichtung 400 werden die Abweichungssignale, die durch die Fehlerblöcke 206 bis 209 erzeugt wurden, in den Summierknoten 401 bis 404 zu den Abweichungssignalen, die durch die Fehlerblöcke 315 bis 318 erzeugt wurden, addiert. Die Ausgangssignale der Summierknoten 401 bis 404 werden wiederum zu den Abweichungssignalen, die durch die Fehlerblöcke 315 bis 318 erzeugt wurden, addiert. Es werden nur Abweichungssignale bezüglich desselben Modulationssignals addiert, womit "globale" Abweichungssignale für jedes erzeugbare Modulationssignal erhalten werden.

Es wird also ein summarisches Fehlerkriterium angewandt, indem die "Einzelfehler", die durch die Regelungseinheiten 200, 300 für die gegebenen Zustände a), b), c) und d) ermittelt wurde, addiert werden. Der Zustand mit dem kleinsten Summenfehler wird vom Entscheider 420 ausgewählt und bestimmt den gegenwärtigen Modulationszustand sowie die Schalterstellung (die Schalter 205, 319 sowie 319' werden simultan und auf identische Art und Weise geschaltet). Indem der Summenfehler möglichst klein gehalten wird, wird bewirkt, dass stets diejenige physikalische Größe vorrangig geregelt wird, die am meisten zum Summenfehler beiträgt, d. h., die den größten "Regelungsbedarf" hat.

Die Fehlerblöcke 206 bis 209, 315 bis 318 sowie 315' bis 318' können unterschiedlich ausgestaltet sein, um jeweilige Abweichungssignale unterschiedlich zu gewichten. So könnten beispielsweise die Einzelfehler für die Regelung der Resonanzfrequenz und für die Regelung der Anregungsschwingung/Ausleseschwingung unterschiedlich gewichtet werden, oder die Betrags- und Phasenabweichung gegenüber der Vorgabefunktion bilden, und hieraus ein Fehlerkriterium ableiten. Die Anregung erfolgt über das (komplexe) Basisbandsignal $x(t)$ getrennt nach In-Phase- und Quadraturkomponente durch Hochmischen auf die Resonanzfrequenz $\omega$. Die Abstimmung auf diese Frequenz $\omega$ kann nur dann exakt erfolgen, wenn die Parameter des realen Schwingers (etwa $\omega_a, \omega_b, \omega_c, \omega_d$) mit hinreichender Genauigkeit bekannt sind. Ist dies nicht der Fall, so können über zusätzliche Hilfsregelkreise die Elemente der Matrizen $A_x^*$ und $M_x^{-1}$, $x = a,b,c,d$ auf die korrekten Werte geregelt werden (d.h. es werden $\omega_a, \omega_b, \omega_c, \omega_d$ ermittelt, und in Abhängigkeit davon die Matrizen $A_x^*$ und $M_x^{-1}$, $x = a,b,c,d$ gebildet.

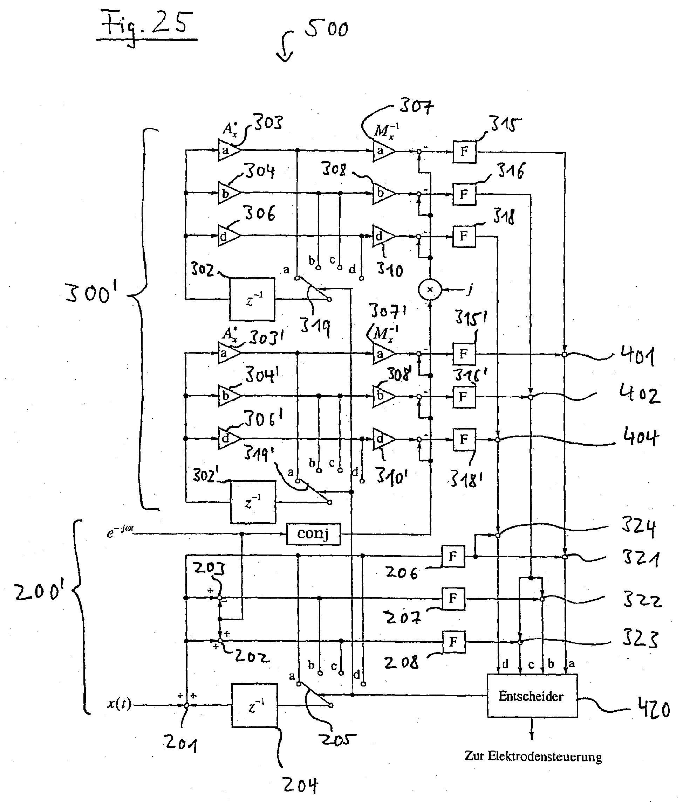

Bei symmetrischen Elektroden ist $\omega_b = \omega_c$ und $F_a = F_d = 0$. Diese Tatsache lässt sich zur Bildung eines vereinfachten Systems ausnützen, indem identische Systembestandteile eingespart werden: In Fig. 25 ist eine Regeleinheit 500 gezeigt, die sich aus einer Regelungseinheit 200' und einer Regelungseinheit 300' zusammensetzt. In der Regelungseinheit 300' wird die Auswirkung des Modulationssignals c) auf den simulierten Eigenschwihgungsvorgang nicht untersucht, da die Auswirkung identisch ist zu der Auswirkung, die das Modulationssignal b) auf den simulierten Eigenschwingungsvorgang haben würde. In der Regelungseinheit 200' wird die Auswirkung des Modulationssignals d) auf den Schwingungsvorgang des Resonators nicht untersucht, da die Auswirkung identisch ist zu der Auswirkung, die das Modulationssignal a) auf den Schwingungsvorgang des Resonators haben würde. Entsprechend unterschiedlich fallen auch die Ausgestaltungen der Addierknoten aus.

**Anhang 1: Umwandlung der allgemeinen in eine symmetrische Zustandsvariablenform**

Gegeben sei die Übergangsmatrix $A$ eines allgemeinen diskreten Systems 2. Ordnung:

$$A = \begin{bmatrix} a_{11} & a_{12} \\ a_{21} & a_{22} \end{bmatrix} \tag{34}$$

Ferner sei

$$g = \frac{a_{22} - a_{11}}{2} \tag{35}$$

$$f = g^2 + a_{12}a_{21} \tag{36}$$

$$h = \sqrt{|f|} \tag{37}$$

$$b_1 = \frac{a_{12}}{h} \tag{38}$$

$$b_2 = \frac{g}{h} \tag{39}$$

Dann ergibt sich für $f < 0$ mit

$$M = \begin{bmatrix} \frac{1}{b_1} & 0 \\ -\frac{b_2}{b_1} & 1 \end{bmatrix}; \ M^{-1} = \begin{bmatrix} b_1 & 0 \\ b_2 & 1 \end{bmatrix} \tag{40}$$

die Übergangsmatrix $A'$ des symmetrischen Systems:

$$A' = M \cdot A \cdot M^{-1} = \begin{bmatrix} c & +h \\ +h & c \end{bmatrix} \tag{41}$$

mit

$$c = \frac{a_{11} + a_{22}}{2} \tag{42}$$

Mit

$$N = \begin{bmatrix} (\frac{1}{\sqrt{2}}) & \frac{j}{\sqrt{2}} \\ \frac{j}{\sqrt{2}} & \frac{1}{\sqrt{2}} \end{bmatrix}, \quad N^{-1} = \begin{bmatrix} (\frac{1}{\sqrt{2}}) & \frac{-j}{\sqrt{2}} \\ \frac{-j}{\sqrt{2}} & \frac{1}{\sqrt{2}} \end{bmatrix} \tag{43}$$

wird

$$A'' = N \cdot M \cdot A \cdot M^{-1} \cdot N^{-1} = N \cdot A' \cdot N^{-1} = \begin{bmatrix} c - jh & 0 \\ 0 & c + jh \end{bmatrix} \tag{44}$$

(Jordan'sche Normalform).

**Anhang 2: Exponentiation einer quadratischen Matrix 2. Ordnung**

Gegeben sei eine quadratische Matrix 2. Ordnung:

$$A = \begin{bmatrix} a_{11} & a_{12} \\ a_{21} & a_{22} \end{bmatrix} \tag{45}$$

Ferner sei

$$g = \frac{a_{22} - a_{11}}{2} \tag{46}$$

$$f = g^2 + a_{12} a_{21} \tag{47}$$

$$h = \sqrt{|f|} \tag{48}$$

$$c = \frac{a_{11} + a_{22}}{2} \tag{49}$$

Dann ist für $f < 0$:

$$e^A = e^c \begin{bmatrix} \cos(h) - g\frac{\sin(h)}{h} & a_{12}\frac{\sin(h)}{h} \\ a_{21}\frac{\sin(h)}{h} & \cos(h) + g\frac{\sin(h)}{h} \end{bmatrix} = e^c \left( \cos(h) \begin{bmatrix} 1 & 0 \\ 0 & 1 \end{bmatrix} + \frac{\sin(h)}{h} \begin{bmatrix} -g & a_{12} \\ a_{21} & g \end{bmatrix} \right) \tag{50}$$

und für $f > 0$:

$$e^A = e^c \begin{bmatrix} \cosh(h) - g\frac{\sinh(h)}{h} & a_{12}\frac{\sinh(h)}{h} \\ a_{21}\frac{\sinh(h)}{h} & \cosh(h) + g\frac{\sinh(h)}{h} \end{bmatrix} = e^c \left( \cosh(h) \begin{bmatrix} 1 & 0 \\ 0 & 1 \end{bmatrix} + \frac{\sinh(h)}{h} \begin{bmatrix} -g & a_{12} \\ a_{21} & g \end{bmatrix} \right) \tag{51}$$

Setzt man

$$cox(f) = \begin{cases} \cos(\sqrt{-f}) & f < 0 \\ 1 & f = 0 \\ \cosh(\sqrt{f}) & f > 0 \end{cases} \qquad (52)$$

$$six(f) = \begin{cases} \dfrac{\sin(\sqrt{-f})}{\sqrt{-f}} & f < 0 \\ 1 & f = 0 \\ \dfrac{\sinh(\sqrt{f})}{\sqrt{f}} & f > 0 \end{cases} \qquad (53)$$

so ergibt sich für $e^A$:

$$e^A = e^c\left( cox(f)\begin{bmatrix} 1 & 0 \\ 0 & 1 \end{bmatrix} + six(f)\begin{bmatrix} -g & a_{12} \\ a_{21} & g \end{bmatrix} \right) \qquad (54)$$

**Patentansprüche**

1. Verfahren zur Steuerung/Regelung einer physikalischen Größe eines dynamischen Systems auf einen bestimmten Sollwert/Sollwertverlauf,
   wobei unter Verwendung eines Pulsmodulators (8) eine Folge diskreter Modulationssignale erzeugt wird und
   wobei durch die Folge diskreter Modulationssignale die Steuerung/Regelung der physikalischen Größe bewirkt wird
   **gekennzeichnet durch**
   das wiederholte Durchführen folgender Schritte:

   a) Ermitteln eines exakten Werts oder einer Approximation für die Abweichung zwischen dem momentanen Sollwert und dem momentanen tatsächlichen Wert der physikalischen Größe,
   b) Ermitteln der jeweiligen Änderung der Abweichung, die das Beibehalten des momentanen Modulationssignals beziehungsweise das Überwechseln auf die anderen Modulationssignale zur Folge haben würde,
   c) Erzeugen desjenigen Modulationssignals, das zur besten Approximation des momentanen Sollwerts führt.

2. Verfahren nach Anspruch 1,
   **dadurch gekennzeichnet,**
   **dass** das System ein mikromechanischer Sensor (1) mit einem Resonator (R) ist.

3. Verfahren nach Anspruch 2,
   **dadurch gekennzeichnet,**
   **dass** die zu steuernde/regelnde physikalische Größe eine Resonanzfrequenz des Resonators (R) ist.

4. Verfahren nach Anspruch 2,
   **dadurch gekennzeichnet,**
   **dass** die zu steuernde/regelnde physikalische Größe die Amplitude/Phase einer Schwingung des Resonators (R) ist.

5. Verfahren nach Anspruch 3,
   **dadurch gekennzeichnet,**

   - **dass** zur Regelung der Resonanzfrequenz des Resonators (R) die Schwingungsantwort des Resonators (R), die aus der Beaufschlagung des Resonators (R) mit einer Modulationssignal-Folge resultiert, simuliert wird, und die Modulationssignal-Folge so gewählt wird, dass sich in der Simulation eine möglichst genaue Approximation eines Schwingungs-Sollwertverlaufs des Resonators (R) ergibt, wobei die Frequenz des Schwingungs-Sollwertverlaufs die zu regelnde Resonanzfrequenz ist, und
- **dass** der Resonator (R) mit der so erhaltenen Modulationssignal-Folge beaufschlagt wird.

6.  Verfahren nach Anspruch 5,
    **dadurch gekennzeichnet,**
    **dass** die Erzeugung der Modulationssignal-Folge zur Regelung der Resonanzfrequenz dadurch erfolgt, dass in der Simulation gleichzeitig Amplitude und Phase der Schwingungsantwort auf bestimmte Sollwerte/Sollwertverläufe geregelt werden, indem:

    a) für jedes erzeugbare Modulationssignal eine effektive Gesamtabweichung (ea, eb) berechnet wird, die gegeben ist aus der Summe der Abweichungen zwischen den momentanen Sollwerten und entsprechenden in der Simulation geregelten Werten, die aus dem Beibehalten des Modulationssignals beziehungsweise dem Überwechseln in das Modulationssignal resultieren würden,
    b) das Modulationssignal ausgewählt wird, für das die berechnete effektive Gesamtabweichung (ea, eb) am geringsten ist,
    c) die Schritte a) und b) mehrmals wiederholt werden.

7.  Verfahren nach Anspruch 5 oder 6,
    **dadurch gekennzeichnet,**
    **dass** simultan zwei Schwingungsantworten des Resonators, die aus der Beaufschlagung des Resonators (R) mit einer Modulationssignal-Folge resultieren, simuliert werden, wobei für jede der Schwingungsantworten gleichzeitig Amplitude und Phase der Schwingungsantwort auf bestimmte Sollwerte/Sollwertverläufe geregelt werden, und die Sollphase der einen Schwingungsantwort gegenüber der Sollphase der anderen Schwingungsantwort um die Phase $\pi/2$ verschoben ist, wobei

    a) für jedes erzeugbare Modulationssignal den beiden Simulationen jeweils eine effektive Gesamtabweichung (ea1, eb1, ea2, eb2) zugeordnet wird, die gegeben ist aus der Summe der Abweichungen zwischen den momentanen Sollwerten der Simulation und entsprechenden in der Simulation geregelten Werten, die aus dem Beibehalten des Modulationssignals beziehungsweise dem Überwechseln in das Modulationssignal resultieren würde,
    b) die effektiven Gesamtabweichungen bezüglich desselben Modulationssignals aus beiden Simulationen addiert werden,
    c) das Modulationssignal ausgewählt wird, für das die im vorangehenden Schritt berechnete Summe (ea, eb) am geringsten ist,
    d) die Schritte a) bis c) mehrmals wiederholt werden.

8.  Vorrichtung zur Steuerung/Regelung einer physikalischen Größe eines dynamischen Systems auf einen bestimmten Sollwert/Sollwertverlauf mit
    einem Pulsmodulator (8), durch den eine Folge diskreter Modulationssignale erzeugbar ist.
    wobei durch die Folge diskreter Modulationssignale die Steuerung/Regelung der physikalischen Größe bewirkbar ist;
    **gekennzeichnet durch**

    a) eine Vergleichseinheit (E), **durch** die ein exakter Wert oder eine Approximation für die Abweichung zwischen dem momentanen Sollwert und dem momentanen tatsächlichen Wert der physikalischen Größe ermittelbar ist,
    b) eine mit der Vergleichseinheit (E) verbundene Berechnungseinheit (20, 22, 24), **durch** die die jeweiligen Änderungen der **durch** die Vergleichseinheit ermittelten Abweichung, die das Beibehalten des momentanen Modulationssignals beziehungsweise das Überwechseln auf die anderen Modulationssignate zur Folge haben würde, berechenbar ist,
    c) eine mit der Berechnungseinheit (20, 22, 24) verbundene Entscheidereinheit (27), die in Abhängigkeit der **durch** die Vergleichseinheit berechneten Abweichungs-Änderungen entscheidet, welches Modulationssignal zur besten Approximation des momentanen Sollwerts führt, wobei die **durch** den Pulsmodulator (8) erzeugte Modulationssignal-Folge **durch** die Entscheidereinheit (27) steuerbar ist.

9.  Verfahren zur gleichzeitigen Steuerung/Regelung wenigstens zweier physikalischer Größen eines dynamischen Systems auf bestimmte Sollwerte/Sollwertverläufe,
    wobei:

unter Verwendung eines Pulsmodulators (8) eine Folge diskreter Modulationssignale erzeugt wird und durch die Folge diskreter Modulationssignale die Steuerung/Regelung, der physikalischen Größen bewirkt wird;

**dadurch gekennzeichnet, dass**

a) für jedes erzeugbare Modulationssignal (a, b, c, d) eine effektive Gesamtabweichung berechnet wird, die gegeben ist aus der Summe der exakten Werte beziehungsweise der Approximationen für die Abweichungen zwischen den momentanen Sollwerten und entsprechenden tatsächlichen Werten der physikalischen Größen, die aus dem Beibehalten dieses Modulationssignals beziehungsweise dem Überwechseln in dieses Modulationssignal resultieren würden,
b) das Modulationssignal zur Regelung verwendet wird, für das die berechnete effektive Gesamtabweichung am geringsten ist,
c) die Schritte a) und b) mehrmals wiederholt werden.

**10.** Verfahren nach Anspruch 9,
**dadurch gekennzeichnet,**
**dass** das System ein mikromechanischer Sensor mit einem Resonator (R) ist.

**11.** Verfahren nach Anspruch 10,
**dadurch gekennzeichnet,**
**dass** die zu steuernden/regelnden physikalischen Größen Resonanzfrequenzen oder Amplituden/Phasen der Anregungsschwingung/Ausleseschwingung des Resonators (R) sind.

**12.** Verfahren nach Anspruch 11,
**dadurch gekennzeichnet,**
**dass** bei Regelung der Resonanzfrequenz des Resonators diesbezügliche in Schritt a) zu ermittelnden Resonanzfrequenz-Abweichungs-Approximationen aufgefunden werden, indem:

- ein Eigenschwingungsvorgang des Resonators simuliert wird, den der Resonator bei bestimmten Schwingungs-Anfangsbedingungen sowie nach Beaufschlagung mit den bisher durch den Pulsmodulator erzeugten Modulationssignalen ausführen würde,
- berechnet wird, welche Auswirkung jedes erzeugbare Modulationssignal auf den simulierten Eigenschwingungsvorgang des Resonators haben würde, und die so hypothetisch resultierenden Eigenschwingungs-Verläufe mit einem Eigenschwingungs-Sollwertverlauf verglichen werden, der die gleichen Schwingung-Anfangsbedingungen aufweist, und dessen Schwingungsfrequenz die zu regelnde Resonanzfrequenz ist,
- wobei die Abweichungen zwischen den hypothetisch resultierenden Eigenschwingungs-Verläufen und dem Eigenschwingungs-Sollwertverlauf die zu ermittelnden Resonanzfrequenz-Abweichungs-Approximationen ist.

**13.** Verfahren nach Anspruch 12,
**dadurch gekennzeichnet,**
**dass** der Vergleich der hypothetisch resultierenden Eigenschwlngungs-Verläufe mit dem Eigenschwingungs-Sollwertverlauf den Vergleich vorn entsprechenden Amplituden und Phasen der Verläufe beinhaltet, wobei

- für jedes erzeugbare Modulationssignal eine Gesamtabweichung berechnet wird, die gegeben ist aus der Summe der Abweichungen zwischen den momentanen Sollwerten und entsprechenden Simulationswerten für Amplitude und Phase, die aus dem Beibehalten dieses Modulationssignals beziehungsweise dem Überwechseln in dieses Modulationssignal resultieren würden,
- die Gesamtabweichungen die zu ermittelnden Resonanzfrequenz-Abweichungs-Approximationen sind.

**14.** Verfahren nach Anspruch 13,
**dadurch gekennzeichnet,**
**dass** simultan zwei Eigenschwingungsvorgänge des Resonators simuliert werden, wobei jeder Eigenschwingungsvorgang bezüglich Amplitude und Phase mit jeweiligen Sollwerten/Sollwertverläufen verglichen wird, und die Sollphase des einen Eignenschwingungsvorgangs gegenüber der Sollphase des anderen Eigenschwingungsvorgangs um die Phase $\pi/2$ verschoben ist, wobei

- für Jedes erzeugbare Modulationssignal den beiden Simulationen Jeweils eine Gesamtabweichung zugeordnet wird, die gegeben ist aus der Summe der Abweichungen zwischen den momentanen Sollwerten und entsprechenden Simulationswerten für Amplitude und Phase, die aus dem Beibehalten dieses Modulationssignals beziehungsweise dem Überwechseln in dieses Modulationssignal resultieren würden,
- die Gesamtabweichungen bezüglich desselben Modulationssignals aus beiden Simulationen addiert werden, wobei die im vorangehenden Schritt berechneten Summen die zu ermittelnden Resonanzfrequenz-Abweichungs-Approximationen sind.

**15.** Einrichtung (400, 500) zur gleichzeitigen Steuerung/Regelung wenigstens zweier physikalischer Größen eines dynamischen Systems auf bestimmte Sollwerte/Sollwertverläufe mit
einem Pulsmodulator (8), durch den eine Folge diskreter Modulationssignale erzeugbar ist:

wobei durch die Folge diskreter Modulationssignale die Steuerung/Regelung der physikalischen Größen bewirkbar ist;

**gekennzeichnet durch**

- eine Berechnungseinheit (200, 200', 300, 300'), die für jedes erzeugbare Modulationssignal eine effektive Gesamtabweichung berechnet, die gegeben ist aus der Summe der exakten Werte beziehungsweise der Approximationen für die Abweichungen zwischen den momentanen Sollwerten und entsprechenden tatsächlichen Werten der physikalischen Größen, die aus dem Beibehalten dieses Modulationssignals beziehungsweise dem Überwechseln in dieses Modulationssignal resultieren würden,
- eine mit der Berechnungseinheit (200, 200', 300, 300') verbundene Entscheidereinheit (420), die in Abhängigkeit der **durch** die Berechnungseinheit (200, 200', 300, 300') berechneten effektiven Gesamtabweichungen entscheidet, für welches Modulationssignal die berechnete effektive Gesamtabweichung am geringsten wäre,

wobei die **durch** den Pulsmodulator (8) erzeugte Modulationssignal-Folge durch die Entscheidereinheit (420) gesteuert wird.

## Claims

**1.** A method for controlling/regulating a physical variable of a dynamic system to a specific desired value/desired value profile
wherein a sequence of discrete modulation signals is generated by using a pulse modulator (8), and
wherein the control/regulation of the physical variable is effect by said sequence of discrete modulation signals,
**characterized by**
the repeated execution of the following steps:

a) determining an exact value or an approximation for the deviation between the momentary desired value and the momentary actual value of the physical variable,
b) determining the respective change in the deviation which would result in the maintenance of the momentary modulation signal or the switching over to the other modulation signals respectively,
c) generating that modulation signal which results in the best approximation of the momentary desired value.

**2.** The method as claimed in claim 1,
**characterized in that**
the system is a micromechanical sensor (1) which has a resonator (R).

**3.** The method as claimed in claim 2,
**characterized in that**
the physical variable which must be controlled/regulated is a resonance frequency of the resonator (R).

**4.** The method as claimed in claim 2,
**characterized in that**
the physical variable which must be controlled/regulated is the amplitude/phase of a vibration of the resonator (R).

**5.** The method as claimed in claim 3,
**characterized in that**

- in order to regulate the resonance frequency of the resonator (R), the resonator (R) vibration response which results from the arrival of a modulation signal sequence at the resonator (R) is simulated, and the modulation signal sequence is selected such that a maximally accurate approximation of a desired value profile for a vibration of the resonator (R) is produced in the simulation, wherein the frequency of the desired value profile for the vibration is the resonance frequency which must be regulated, and
- that the resonator (R) is exposed to the modulation signal sequence which is obtained thus.

**6.** The method as claimed in claim 5,
**characterized in that**
the generation of the modulation signal sequence for regulating the resonance frequency is achieved by simultaneously regulating amplitude and phase of the vibration response to specific desired values/desired value profiles in the simulation, wherein:

a) an effective total deviation (ea, eb) is calculated for each generatable modulation signal, said total deviation being obtained from the sum of the deviations between the momentary desired values and corresponding values as regulated in the simulation, which would result from the maintenance of the modulation signal or the switching over to the modulation signal respectively,
b) that modulation signal is selected for which the calculated effective total deviation (ea, eb) is smallest,
c) the steps a) and b) are iteratively repeated.

**7.** The method as claimed in claim 5 or 6,
**characterized in that**
two vibration responses of the resonator are simulated simultaneously, said responses resulting from the arrival at the resonator (R) of a modulation signal sequence, wherein for each of the vibration responses, amplitude and phase of the vibration response are simultaneously regulated to specific desired values/desired value profiles, and the desired phase of the one vibration response is shifted relative to the desired phase of the other vibration response by the phase $\pi/2$, wherein

a) for each generatable modulation signal, the two simulations are each assigned an effective total deviation (ea1, eb1, ea2, eb2) which is derived from the sum of the deviations between the momentary desired values of the simulation and corresponding values which are regulated in the simulation, which would result from the maintenance of the modulation signal or the switching over to the modulation signal respectively,
b) the effective total deviations relating to the same modulation signal from both simulations are added,
c) that modulation signal is selected for which the sum (ea, eb) which is calculated in the previous step is smallest,
d) the steps a) to c) are iteratively repeated.

**8.** A device for controlling/regulating a physical variable of a dynamic system to a specific desired value/desired value profile, which device features
a pulse modulator (8) by means of which a sequence of discrete modulation signals can be generated,
wherein the control/regulation of the physical variable can be effected by said sequence of discrete modulation signals,
**characterized by**

a) a comparison unit (E) by means of which it is possible to determine an exact value or an approximation for the deviation between the momentary desired value and the momentary actual value of the physical variable,
b) a calculation unit (20, 22, 24) which is connected to the comparison unit (E) and by means of which it is possible to calculate the relevant changes in the deviation, as determined by the comparison unit, which would result in the maintenance of the momentary modulation signal or the switching over to the other modulation signals,
c) a decision unit (27) which is connected to the calculation unit (20, 22, 24) and, depending on the deviation changes calculated by the comparison unit, decides which modulation signal results in the best approximation of the momentary desired value, wherein the modulation signal sequence which is generated by the pulse modulator (8) can be controlled by the decision unit (27).

**9.** A method for simultaneously controlling/regulating at least two physical variables of a dynamic system to specific desired values/desired value profiles,
wherein
a sequence of discrete modulation signals is generated by using a pule modulator (8), and

the control/regulation of the physical variables is effected by the sequence of discrete modulation,
**characterized in that**

a) an effective total deviation is calculated for each generatable modulation signal (a, b, c, d), said total deviation being obtained from the sum of the exact values or the approximations for the deviations between the momentary desired values and corresponding actual values of the physical variables, which would result from the maintenance of this modulation signal or the switching over to this modulation signal respectively,
b) that modulation signal which has the smallest calculated effective total deviation is used for the regulation,
c) the steps a) and b) are iteratively repeated.

10. The method as claimed in claim 9,
**characterized in that**
the system is a micromechanical sensor which has a resonator (R).

11. The method as claimed in claim 10,
**characterized in that**
the physical variables to be controlled/regulated are resonance frequencies or amplitudes/phases of the excitation vibration/readout vibration of the resonator (R).

12. The method as claimed in claim 11,
**characterized in that**
when regulating the resonance frequency of the resonator, resonance frequency deviation approximations relating to this, said approximations being determined in step a), are ascertained as follows:

- a natural vibration process of the resonator, which the resonator would execute under specific vibration initial conditions and after exposure to the modulation signals previously generated by the pulse modulator, is simulated,
- the effect which each generatable modulation signal would have on the simulated natural vibration process of the resonator is calculated, and the hypothetically resulting natural vibration profiles are compared with a natural vibration desired value profile which has the same vibration initial conditions and whose vibration frequency is the resonance frequency that must be regulated,
- wherein the deviations between the hypothetically resulting natural vibration profiles and the natural vibration desired value profile represent the resonance frequency deviation approximations that must be determined.

13. The method as claimed in claim 12,
**characterized in that**
the comparison of the hypothetically resulting natural vibration profiles with the natural vibration desired value profile includes the comparison of corresponding amplitudes and phases of the profiles, wherein

- a total deviation is calculated for each generatable modulation signal, said total deviation being obtained from the sum of the deviations between the momentary desired values and corresponding simulation values for amplitude and phase, which would result from the maintenance of this modulation signal or the switching over to this modulation signal respectively,
- the total deviations represent the resonance frequency deviation approximations which must be determined.

14. The method as claimed in claim 13,
**characterized in that**
two natural vibration processes of the resonator are simulated simultaneously, wherein each natural vibration process is compared with relevant desired values / desired value profiles in respect of amplitude and phase, and the desired phase of the one natural vibration process is shifted relative to the desired phase of the other natural vibration process by the phase $\pi/2$, wherein

- for each generatable modulation signal, a total deviation is assigned in each case to the two simulations, said total deviation being obtained from the sum of the deviations between the momentary desired values and corresponding simulation values for amplitude and phase, which would result from the maintenance of this modulation signal or the switching over to this modulation signal respectively,
- the total deviations relating to the same modulation signal from both simulations are added up, wherein the sums which were calculated in the previous step represent the resonance frequency deviation approximations which must be determined.

15. An entity (400, 500) for simultaneously controlling/regulating at least two physical variables of a dynamic system to specific desired values/desired value profiles, said entity featuring

a pulse modulator (8) by means of which a sequence of discrete modulation signals can be generated;
wherein the control/regulation of the physical variables can be effected by the sequence of discrete modulation signals,
**characterized by**

- a calculation unit (200, 200', 300, 300') which, for each generatable modulation signal, calculates an effective total deviation which is derived from the sum of the exact values or the approximations for the deviations between the momentary desired values and corresponding actual values of the physical variables, which would result from the maintenance of this modulation signal or the switching over to this modulation signal respectively,
- a decision unit (420) which is connected to the calculation unit (200, 200', 300, 300') and, depending on the effective total deviations calculated by the calculation unit (200, 200', 300, 300'), decides for which modulation signal the calculated effective total deviation would be smallest,

wherein the modulation signal sequence which is generated by the pulse modulator (8) is controlled by the decision unit (420).

## Revendications

1. Procédé pour commander/réguler une grandeur physique d'un système dynamique à une valeur de consigne/courbe de valeur de consigne définie,
étant précisé qu'à l'aide d'un modulateur d'impulsions (8), une suite de signaux de modulation discrets sont générés, et
que la suite de signaux de modulation discrets provoque la commande/régulation de la grandeur physique,
**caractérisé par**
la réalisation répétée des étapes suivantes :

a) recherche d'une valeur exacte ou d'une approximation pour l'écart entre la valeur de consigne momentanée et la valeur réelle momentanée de la grandeur physique,
b) recherche de la variation de l'écart qui entraînerait le maintien du signal de modulation momentané ou le passage aux autres signaux de modulation,
c) production du signal de modulation qui entraîne la meilleure approximation de la valeur de consigne momentanée.

2. Procédé selon la revendication 1, **caractérisé en ce que** le système est un capteur micromécanique (1) avec un résonateur (R).

3. Procédé selon la revendication 2, **caractérisé en ce que** la grandeur physique à commander/réguler est une fréquence de résonance du résonateur (R).

4. Procédé selon la revendication 2, **caractérisé en ce que** la grandeur physique à commander/réguler est l'amplitude/la phase d'une oscillation du résonateur (R).

5. Procédé selon la revendication 3, **caractérisé**

- **en ce que** pour la régulation de la fréquence de résonance du résonateur (R), la réponse d'oscillation du résonateur (R) qui résulte de la sollicitation du résonateur (R) avec la suite de signaux de modulation est simulée, et la suite de signaux de modulation est choisie de telle sorte qu'il y ait dans la simulation une approximation aussi précise que possible d'une courbe de valeur de consigne d'oscillation du résonateur (R), étant précisé que la fréquence de ladite courbe de valeur de consigne d'oscillation est la fréquence de résonance à réguler, et
- **en ce que** le résonateur (R) est sollicité avec la suite de signaux de modulation ainsi obtenue.

6. Procédé selon la revendication 5, **caractérisé en ce que** la production de la suite de signaux de modulation pour réguler la fréquence de résonance a lieu grâce au fait que dans la simulation, l'amplitude et la phase de la réponse d'oscillation sont simultanément régulées à des valeurs de consigne/courbes de valeur de consigne définies, et ce de la manière suivante :

a) pour chaque signal de modulation apte à être généré est calculé un écart total effectif (ea, eb) qui est défini à partir de la somme des écarts entre les valeurs de consigne momentanées et des valeurs correspondantes, régulées dans la simulation, qui résulteraient du maintien du signal de modulation ou du passage au signal de modulation,

b) le signal de modulation pour lequel l'écart total effectif (ea, eb) calculé est le plus faible est choisi,

c) les étapes a) et b) sont répétées plusieurs fois.

7. Procédé selon la revendication 5 ou 6, **caractérisé en ce que** simultanément, deux réponses d'oscillation du résonateur qui résultent de la sollicitation du résonateur (R) avec une suite de signaux de modulation sont simulées, étant précisé que pour chacune des réponses d'oscillation, l'amplitude et la phase de la réponse d'oscillation sont simultanément régulées à des valeurs de consigne/courbes de valeur de consigne définies, et la phase de consigne d'une réponse d'oscillation est décalée de la phase n/2 par rapport à la phase de consigne de l'autre réponse d'oscillation, étant précisé :

a) que pour chaque signal de modulation apte à être généré sont associés aux deux simulations des écarts totaux effectifs respectifs (ea1, eb1, ea2, eb2) qui sont définis à partir de la somme des écarts entre les valeurs de consigne momentanées de la simulation et des valeurs correspondantes régulées dans la simulation, qui résulteraient du maintien du signal de modulation ou du passage au signal de modulation,

b) que les écarts totaux effectifs par rapport au même signal de modulation, à partir des deux simulations, sont additionnés,

c) que c'est le signal de modulation pour lequel la somme (ea, eb) calculée lors de l'étape précédente est la plus faible qui est choisi,

d) les étapes a) à c) sont répétées plusieurs fois.

8. Dispositif pour commander/réguler une grandeur physique d'un système dynamique à une valeur de consigne/courbe de valeur de consigne définie, avec
un modulateur d'impulsions (8) grâce auquel peuvent être générés une suite de signaux de modulation discrets, étant précisé que par la suite de signaux de modulation discrets peut être provoquée la commande/régulation de la grandeur physique,
**caractérisé par**

a) une unité de comparaison (E) grâce à laquelle une valeur exacte ou une approximation pour l'écart entre la valeur de consigne momentanée et la valeur réelle momentanée de la grandeur physique peut être recherchée,

b) une unité de calcul (20, 22, 24), reliée à l'unité de comparaison (E), grâce à laquelle peuvent être calculées les variations respectives de l'écart, recherché par l'unité de comparaison, qui entraînerait le maintien du signal de modulation momentané ou le passage aux autres signaux de modulation,

c) une unité de décision (27), reliée à l'unité de calcul (20, 22, 24), qui décide, en fonction des variations d'écart calculées par l'unité de comparaison, quel signal de modulation mène à la meilleure approximation de la valeur de consigne momentanée, état précisé que la suite de signaux de modulation générée par le modulateur d'impulsions (8) est apte à être commandée par l'unité de décision (27).

9. Procédé pour commander/réguler simultanément au moins deux grandeurs physiques d'un système dynamique à des valeurs de consigne/courbes de valeur de consigne définies,
étant précisé qu'à l'aide d'un modulateur d'impulsions (8), une suite de signaux de modulation discrets sont générés, et
que la suite de signaux de modulation discrets provoque la commande/régulation des grandeurs physiques,
**caractérisé en ce que**

a) pour chaque signal de modulation (a, b, c, d) apte à être généré est calculé un écart total effectif qui est défini à partir de la somme des valeurs exactes ou des approximations pour les écarts entre les valeurs de consigne momentanées et des valeurs réelles correspondantes des grandeurs physiques qui résulteraient du maintien de ce signal de modulation ou du passage à ce signal de modulation,

b) c'est le signal de modulation pour lequel l'écart total effectif calculé est le plus faible qui est utilisé,

c) les étapes a) et b) sont répétées plusieurs fois.

**10.** Procédé selon la revendication 9, **caractérisé en ce que** le système est un capteur micromécanique avec un résonateur (R).

**11.** Procédé selon la revendication 10, **caractérisé en ce que** les grandeurs physiques à commander/réguler sont des fréquences de résonance ou des amplitudes/phases de l'oscillation d'excitation/oscillation de sélection du résonateur (R).

**12.** Procédé selon la revendication 11, **caractérisé en ce que** lors de la régulation de la fréquence de résonance du résonateur, les approximations d'écart de fréquence de résonance à rechercher lors de l'étape a) à ce sujet sont trouvées, en :

- simulant une opération d'oscillation propre du résonateur que ledit résonateur effectuerait dans des conditions initiales d'oscillation définies et après sollicitation avec les signaux de modulation générés jusque là par le modulateur d'impulsions,
- calculant quel effet chaque signal de modulation apte à être généré aurait sur l'opération d'oscillation propre simulée du résonateur, et en comparant les courbes d'oscillation propre qui en résultent ainsi hypothétiquement avec une courbe de valeur de consigne d'oscillation propre qui présente les mêmes conditions initiales d'oscillation et dont la fréquence d'oscillation est la fréquence de résonance à réguler,
- étant précisé que les écarts entre les courbes d'oscillation propre qui en résultent hypothétiquement et la courbe de valeur de consigne d'oscillation propre constituent les approximations d'écart de fréquence de résonance à rechercher.

**13.** Procédé selon la revendication 12, **caractérisé en ce que** la comparaison des courbes d'oscillation propre qui en résultent hypothétiquement avec la courbe de valeur de consigne d'oscillation propre contient la comparaison d'amplitudes et de phases correspondantes des courbes, étant précisé

- que pour chaque signal de modulation apte à être généré est calculé un écart total qui est défini à partir de la somme des écarts entre les valeurs de consigne momentanées et des valeurs de simulation correspondantes, pour l'amplitude et la phase, qui résulteraient du maintien de ce signal de modulation ou du passage à ce signal de modulation,
- que les écarts totaux sont les approximations d'écart de fréquence de résonance à rechercher.

**14.** Procédé selon la revendication 13, **caractérisé en ce que** simultanément, deux opérations d'oscillation propre du résonateur sont simulées, étant précisé que chaque opération d'oscillation propre est comparée, pour l'amplitude et la phase, avec des valeurs de consigne/courbes de valeur de consigne respectives, et que la phase de consigne d'une opération d'oscillation propre est décalée de la phase $\pi/2$ par rapport à la phase de consigne de l'autre opération d'oscillation propre, étant précisé :

- que pour chaque signal de modulation apte à être généré sont associés aux deux simulations des écarts totaux respectifs qui sont définis à partir de la somme des écarts entre les valeurs de consigne momentanées et des valeurs de simulation correspondantes pour l'amplitude et la phase, qui résulteraient du maintien de ce signal de modulation ou du passage à ce signal de modulation,
- que les écarts totaux par rapport au même signal de modulation, à partir des deux simulations, sont additionnés, étant précisé que les sommes calculées lors de l'étape précédente sont les approximations d'écart de fréquence de résonance à rechercher.

**15.** Dispositif (400, 500) pour commander/réguler simultanément au moins deux grandeurs physiques d'un système dynamique à des valeurs de consigne/courbes de valeur de consigne définies, avec
un modulateur d'impulsions (8) grâce auquel une suite de signaux de modulation discrets peuvent être générés,
étant précisé que la suite de signaux de modulation discrets est apte à provoquer la commande/régulation des grandeurs physiques,
**caractérisé par**

- une unité de calcul (200, 200', 300, 300') qui, pour chaque signal de modulation apte à être généré, calcule un écart total effectif qui est défini à partir de la somme des valeurs exactes ou des approximations pour les écarts entre les valeurs de consigne momentanées et des valeurs réelles correspondantes des grandeurs physiques qui résulteraient du maintien de ce signal de modulation ou du passage au signal de modulation,
- une unité de décision (420), reliée à l'unité de calcul (200, 200', 300, 300'), qui décide, en fonction des écarts totaux effectifs calculés par ladite unité de calcul (200, 200', 300, 300'), pour quel signal de modulation l'écart total effectif calculé serait le plus faible, étant précisé que la suite de signaux de modulation générée par le modulateur d'impulsions (8) est commandée par l'unité de décision (420).

Fig. 1

Fig.2

Fig.3

Fig.4

Fig.5

Fig.6

Fig.7

Fig. 8

Fig. 9

Fig. 10

Fig. 11

Fig. 12

Fig. 13

Fig. 14

Fig. 15

Fig. 16

30

Fig. 17

31

Fig. 18

32

EP 1 825 218 B1

Fig. 19

Fig. 20

Fig. 21

Fig. 22

Fig. 23

Fig. 24

Fig. 25

Zur Elektrodensteuerung

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10248733 A1